(19) Europäisches Patentamt
European Patent Office
Office européen des brevets

(11) EP 3 088 469 B1

(12) # EUROPEAN PATENT SPECIFICATION

(45) Date of publication and mention of the grant of the patent:
**10.10.2018 Bulletin 2018/41**

(21) Application number: **14875023.5**

(22) Date of filing: **19.12.2014**

(51) Int Cl.:
***C08L 71/12*** *(2006.01)* ***C08K 5/51*** *(2006.01)*
***C08L 25/04*** *(2006.01)* ***C08L 53/02*** *(2006.01)*
***H02S 40/34*** *(2014.01)* ***C08L 25/06*** *(2006.01)*
***C08F 297/04*** *(2006.01)* ***C08K 5/523*** *(2006.01)*
***C08K 5/5313*** *(2006.01)*

(86) International application number:
**PCT/JP2014/083780**

(87) International publication number:
**WO 2015/098770 (02.07.2015 Gazette 2015/26)**

(54) **FLAME-RETARDANT RESIN COMPOSITION AND CONNECTION STRUCTURE FOR SOLAR POWER GENERATION MODULE**

FLAMMHEMMENDE HARZZUSAMMENSETZUNG UND VERBINDUNGSSTRUKTUR FÜR FOTOVOLTAISCHES STROMERZEUGUNGSMODUL

COMPOSITION DE RÉSINE RETARDATRICE DE FLAMME ET STRUCTURE DE CONNEXION POUR UN MODULE DE PRODUCTION D'ÉLECTRICITÉ PHOTOVOLTAÏQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2013 JP 2013272537**

(43) Date of publication of application:
**02.11.2016 Bulletin 2016/44**

(73) Proprietor: **Asahi Kasei Kabushiki Kaisha**
**Chiyoda-ku**
**Tokyo**
**101-8101 (JP)**

(72) Inventors:
- **ISHII, Tadayuki**
  **Tokyo 101-8101 (JP)**
- **KONO, Hiroyuki**
  **Tokyo 101-8101 (JP)**

(74) Representative: **Strehl Schübel-Hopf & Partner**
**Maximilianstrasse 54**
**80538 München (DE)**

(56) References cited:
**EP-A1- 2 048 198** **EP-A1- 2 218 753**
**EP-A1- 2 360 210** **WO-A2-2012/082535**
**WO-A2-2013/121363** **JP-A- H10 208 704**
**JP-A- 2001 316 540** **JP-A- 2008 037 970**
**JP-A- 2009 263 460** **JP-A- 2010 123 933**
**JP-A- 2010 260 995** **JP-A- 2013 234 288**
**JP-A- 2013 234 288** **JP-A- 2014 159 513**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 088 469 B1

## Description

Technical Field

The present invention relates to a flame retardant resin composition and a connection structure for a solar power generation module.

Background Art

A Mixed resin (hereinafter also referred to as "m-PPE resin") of a polyphenylene ether (hereinafter also referred to as "PPE") resin (hereinafter also referred to as "PPE resin") and a styrene-based resin has better moldability compared to PPE resin and excellent heat resistance similar to PPE, as well as excellent electrical properties, dimensional stability, impact resistance, acid resistance and alkaline resistance, with low water absorbency and a low density.

The m-PPE resin has characteristics of environmental adaptability and safety and health, achieving flame retardance without use of harmful halogen compounds or antimony compounds. Therefore, the m-PPE resins are widely used in applications such as various kinds of electric/electronic components, office machine components, automobile components, building materials, and other various kinds of external materials and industrial products.

As described above, in a conventional method to make m-PPE resins flame retardant, organic phosphate esters have been typically used without use of harmful halogen compounds or antimony compounds.

Examples of the organic phosphate esters include monophosphates such as triphenyl phosphate, cresyl diphenyl phosphate and tricresyl phosphate, and condensed phosphates derived from phenols such as resorcinol and bisphenol A and phosphorus trichloride compounds.

However, the resin compositions rendered flame retardant by using above organic phosphates have various kinds of problems such as deterioration in physical properties including heat resistance, deterioration in water absorption property under high temperature and high humidity, fuming in injection molding, mold-staining during molding (mold deposit and transfer of flame retardants to a mold), and defects of a molded products caused by adhered substances (appearance defects).

Among the organic phosphates , it is said that resin compositions using a condensed phosphate ester derived from a phenol compound such as bisphenol A and a phosphorus compound as a flame retardant are relatively less suffered from the problems (e.g. refer to Patent Documents 1 to 3 and 6).

Meanwhile, a resin composition including a thermoplastic resin blended with a phosphinate salt or a diphosphinate salt and/or a condensate thereof and a specific nitrogen compound as flame retardants is disclosed (e.g. refer to Patent Document 4) . The resin composition, however, is insufficient in flame retardance, impact resistance and the like, and causes practical problems including adhesion of the flame retardant to a mold during injection molding (mold deposit).

In recent years, as typified by photovoltaic power generation systems (e.g. Patent Document 5), products have a longer service life with a long-term usage period. Further, in order to use products under harsher installation environments, resistance to heat aging (properties for maintaining performance even when it exposed for a long time under high temperature usage environment) and resistance of the product resin under high temperature and high humidity environment have been required as important properties.

List of Prior Art Documents

Patent Document

Patent Document 1: Japanese Patent Laid-Open No. 55-118957
Patent Document 2: Japanese Patent Laid-Open No. 05-186681
Patent Document 3: Japanese Patent Laid-Open No. 07-053876
Patent Document 4: National Publication of International Patent Application No. 2000-508365
Patent Document 5: Japanese Patent Laid-Open No. 2010-123933
Patent Document 6: JP20132342883

Summary of Invention

Problems to be Solved by Invention

As described above, in recent years, products are required to have a longer service life with a prolonged usage years, and installation environment is under harsh conditions in many cases. A resin composition which can effectively suppress reduction in flame retardance when it exposed under the harsh environment for a long time, however, has not been obtained yet.

Accordingly, an object of the present invention is to provide a flame retardant resin composition that has excellent heat resistance, mechanical properties, electrical properties, water resistance and chemical resistance in practical applications, and hardly ever causes problems such as fuming in injection molding and adhesion of the flame retardant to a mold, and can effectively suppress reduction in flame retardance when it exposed under high temperature environment for a long period.

Means for Solving Problems

As a result of extensive study to solve the problems of the conventional art by the present inventors, it was found that a flame retardant resin composition which contains a polyphenylene ether resin or a mixed resin of a polyphenylene ether resin and a styrene-based resin (A), a hydrogenated block copolymer (B), a specified phosphorus-containing flame retardant (C) can effectively suppress reduction in flame retardance even when exposed under high temperature environment for a long period. The present invention was thus accomplished. In other words, the present invention is as follows.

[1] A flame retardant resin composition comprising:

70 to 99 parts by mass of a polyphenylene ether resin, or a mixed resin of a polyphenylene ether resin and a styrene-based resin (A);
1 to 30 parts by mass of a hydrogenated block copolymer (B) ; and
5 to 30 parts by mass of a phosphorus-containing flame retardant (C) based on the total 100 parts by mass of the (A) and the (B);
wherein the component (A) comprises 70 to 100 % by mass of a polyphenylene ether resin (A-1) and 0 to 30 % by mass of a styrene-based resin (A-2); and
the component (C) comprises a phosphate ester compound (C-1) and at least one selected from the group consisting of a phosphinate salt represented by the following general formula (I), a diphosphinate salt represented by the following general formula (II), and a condensate thereof (C-2):

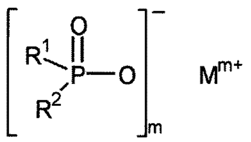

(I)

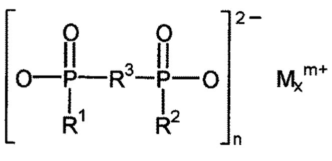

(II)

wherein $R^1$ and $R^2$ are a linear or branched C1-C6 alkyl group or a C6-C10 aryl group may be the same or different; $R^3$ is any one selected from the group consisting of a linear or branched C1-C10 alkylene group, a C6-C10 arylene group, a C6-C10 alkylarylene group, and a C6-C10 arylalkylene group;
M is one or more selected from the group consisting of a calcium ion, a magnesium ion, an aluminum ion, a zinc ion, a bismuth ion, a manganese ion, a sodium ion, a potassium ion, and a cationized nitrogen base; m is 1, 2 or 3; n is 1 to 3; x is 1 or 2; and 2n=mx characterized in that the (C) comprises: 50 to 70 % by mass of the phosphate ester compound (C-1); and 30 to 50 % by mass of at least one selected from the group consisting of a phosphinate salt represented by the general formula (I), a diphosphinate salt represented by the general formula (II), and a condensate thereof (C-2).

[2] The flame retardant resin composition according to [1], wherein the (A) comprises 80 to 100 % by mass of (A-1) and 0 to 20 % by mass of (A-2).

[3] The flame retardant resin composition according to [1] or [2], wherein the (A) comprises 90 to 100 % by mass of (A-1) and 0 to 10 % by mass of (A-2).

[4] The flame retardant resin composition according to any one of [1] to [3], wherein the phosphate ester compound (C-1) is a phosphate ester compound represented by the following general formula (III) or the general formula (IV):

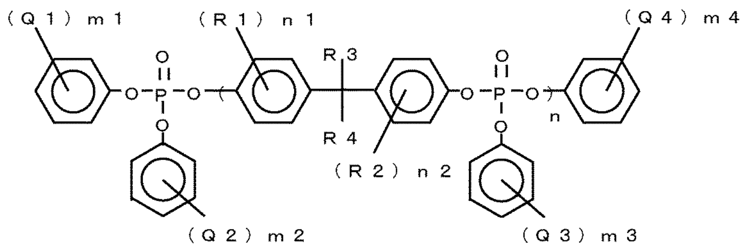

・・・(III)

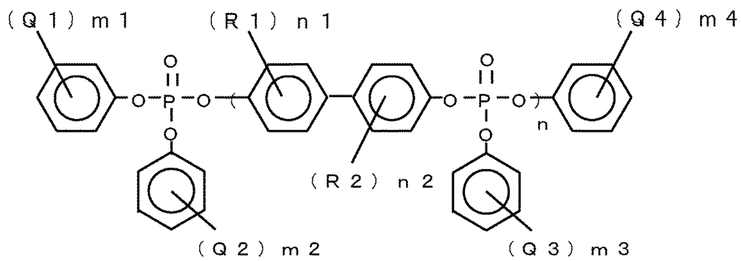

・・・(IV)

wherein Q1, Q2, Q3 and Q4 each independently represent an alkyl group having 1 to 6 carbon atoms, R1 and R2 represent a methyl group, and R3 and R4 each independently represent a hydrogen atom or a methyl group; n is an integer of 1 or more, n1 and n2 each independently represent an integer of 0 to 2, and m1, m2, m3 and m4 each independently represent an integer of 0 to 3.

[5] The flame retardant resin composition according to any one of [1] to [4], further comprises 0.1 to 5.0 % by mass of titanium oxide (D).

[6] The flame retardant resin composition according to any one of [1] to [5], wherein the component (C-2) has an average particle diameter of more than 1.0 μm and 10 μm or less.

[7] The flame retardant resin composition according to any one of [1] to [6], have an inorganic filler content of 5.0 % by mass or less.

[8] The flame retardant resin composition according to any one of [1] to [7], wherein the hydrogenated block copolymer (B) has a Li content of 100 ppm or less.

[9] The flame retardant resin composition according to any one of [1] to [8], wherein increasing rate of residue amount that relate to the residue amount of an injection molded product of the flame retardant resin composition having a thickness of 1.5 mm obtained by thermogravimetric analysis (measurement conditions: temperature rising from room temperature to 700°C at a heating rate of 20°C/min under nitrogen atmosphere), and the residue amount of the injection molded product of the flame retardant resin composition having a thickness of 1.5 mm obtained by the thermogravimetric analysis after heat aging under conditions at 150°C for 500 hours is 12% or less.

[10] The flame retardant resin composition according to any one of [1] to [9 ], wherein the injection molded product of the flame retardant resin composition having a thickness of 1.5 mm has a flame retardance specified in the UL-94 standard in the range of V-1 or higher, after heat aging under conditions at 150°C for 500 hours.

[11] The flame retardant resin composition according to any one of [1] to [10 ], wherein the injection molded product having a thickness of 1.5 mm has a flame retardance specified in the UL-94 standard in the range of V-0, after heat aging under conditions at 150°C for 500 hours.

[12] A connection structure for a photovoltaic power generation module comprising the flame retardant resin composition according to any one of [1] to [11].

[13] The connection structure for the photovoataic power generation module according to [12] , wherein the structure is a junction box for photovoataic power generation modules.

[14] The connection structure for the solar power generation module according to [12 , wherein the structure is a connector for photovoataic power generation modules.

Advantages of Invention

The present invention provides a flame retardant resin composition that has excellent in heat resistance, mechanical properties, electrical properties, water resistance and chemical resistance in practical applications, and hardly ever causes problems such as fuming in injection molding and adhesion of the flame retardant to a mold, and can effectively suppress reduction in flame retardance when it exposed under high temperature environment for a long period.

Mode for Carrying Out Invention

The embodiments of the present invention (hereinafter referred to as "present embodiments") are described in detail as follows.

The following present embodiments are examples to illustrate the present invention and not intended to limit the present invention thereto. The present invention may be carried out with a proper modification within the scope thereof.

[Flame retardant resin composition]

The flame retardant resin composition of the present embodiment contains:

70 to 99 parts by mass of a polyphenylene ether resin, or a mixed resin of a polyphenylene ether resin and a styrene-based resin (A);
1 to 30 parts by mass of a hydrogenated block copolymer (B) ;
and
5 to 30 parts by mass of a phosphorus-containing flame retardant (C) based on the total 100 parts by mass of the (A) and the (B).

The (A) contains 70 to 100 % by mass of a polyphenylene ether resin (A-1) and 0 to 30 % by mass of a styrene-based resin (A-2) .

The (C) contains a phosphate ester compound (C-1) and at least one selected from the group consisting of a phosphinate salt represented by the following general formula (I), a diphosphinate salt represented by the following general formula (II), and a condensate thereof (C-2).

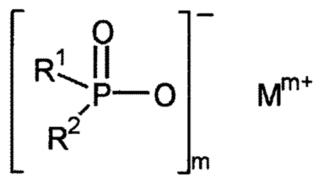

(I)

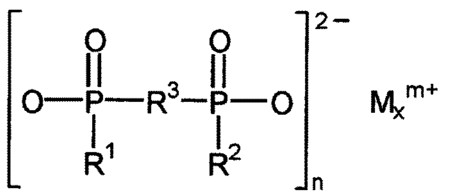

(II)

In the formulas (I) and (II), $R^1$ and $R^2$ are a linear or branched C1-C6 alkyl group or a C6-C10 aryl group may be the same or different.

$R^3$ is any one selected from the group consisting of a linear or branched C1-C10 alkylene group, a C6-C10 arylene group, a C6-C10 alkylarylene group, and a C6-C10 arylalkylene group.

M is one or more selected from the group consisting of a calcium ion, a magnesium ion, an aluminum ion, a zinc ion, a bismuth ion, a manganese ion, a sodium ion, a potassium ion, and a cationized nitrogen base; m is 1, 2 or 3; n is 1 to 3; x is 1 or 2; and 2n=mx.

(Polyphenylene ether resin, or mixed resin of polyphenylene ether resin and styrene-based resin (A))

The flame retardant resin composition of the present embodiment contains a polyphenylene ether resin, or a mixed resin of a polyphenylene ether resin and a styrene-based resin (A) (described as component (A) or (A) in some cases).

The component (A) contains 70 to 100 % by mass of a polyphenylene ether resin (A-1) and 0 to 30 % by mass of a styrene-based resin (A-2).

<Polyphenylene ether resin (A-1)>

As polyphenylene ether resin (A-1) for use in the present embodiment, any one of a homopolymer including a structural unit represented by the following general formula (V) and a copolymer having a structural unit represented by the following general formula (V) (hereinafter also referred to as simply "polyphenylene ether" in some cases) can be used.

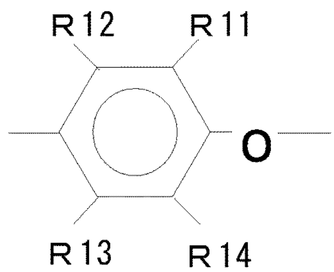

• • • (V)

In the general formula (V), O represents an oxygen atom, R11 to R14 each independently represent any one selected from the group consisting of a hydrogen atom, a halogen atom, a primary or secondary lower alkyl group (herein, "lower alkyl" means any one of C1-C8 alkyl groups), a phenyl group, a haloalkyl group, an aminoalkyl group, a hydrocarbon oxy group, and a halohydrocarbon oxy group having at least two carbon atoms separating a halogen atom and an oxygen atom.

Examples of the homopolymer of polyphenylene ether resin include poly(2,6-dimethyl-1,4-phenylene ether), poly(2-methyl-6-ethyl-1,4-phenylene ether), poly(2-methyl-6-phenyl-1,4-phenylene ether), and poly(2,6-dichloro-1,4-phenylene ether), though not limited thereto.

Examples of the copolymer of polyphenylene ether resin include a copolymer of 2, 6-dimethylphenol and other phenols (e.g. a copolymer with 2,3,6-trimethylphenol and a copolymer with 2-methyl-6-butylphenol as described in Japanese Patent Publication No. 52-17880), though not limited thereto.

Among them, poly(2,6-dimethyl-1,4-phenylene ether), a copolymer of 2,6-dimethylphenol and 2,3,6-trimethylphenol, and a mixture thereof are particularly preferred as polyphenylene ether resin, from the viewpoints of the balance of mechanical properties and the productivity.

Examples of the method for manufacturing the polyphenylene ether resin for use in the present embodiment include known manufacturing methods described in US Patent No. 3306874, No. 3306875, No. 3257357, and No. 3257358, Japanese Patent Laid-Open No. 50-51197, Japanese Patent Publication No. 52-17880, and Japanese Patent Laid-Open No. 63-152628, though not limited thereto.

The reduced viscosity of the polyphenylene ether resin (0.5 g/dl chloroform solution, 30°C, measured by an Ubbelohde viscosity tube) is preferably in the range of 0.30 dl/g to 0.65 dl/g, more preferably in the range of 0.40 dl/g to 0.60 dl/g, furthermore preferably in the range of 0.45 dl/g to 0.55 dl/g, from the viewpoints of molding fluidity and balance of physical properties.

With a reduced viscosity of 0.30 dl/g or more, excellent impact strength and chemical resistance can be obtained. With a reduced viscosity of 0.65 dl/g or less, excellent molding fluidity can be obtained.

In the present embodiment, two or more polyphenylene ether resins having a different reduced viscosity may be blended for preferable use.

The polyphenylene ether resin (A-1) for use in the present embodiment may include a partially or wholly modified polyphenylene ether.

The modified polyphenylene ether as defined herein means a polyphenylene ether modified with a modifying compound which has at least one carbon-to-carbon double or triple bond in the molecular structure and at least any one selected from the group consisting of a carboxylic group, an acid anhydride group, an amino group, a hydroxyl group, and a glycidyl group. One modifying compound may be used alone, or two or more thereof may be used in combination.

Examples of the method for manufacturing the modified polyphenylene ether include methods for reacting polyphenylene ether with modifying compound in presence or absence of a radical initiator with a modifying compound: (1) at a temperature in the range from 100°C to lower than the glass transition temperature of the polyphenylene ether without melting the polyphenylene ether; (2) by melt kneadin at a temperature in the range from the glass transition temperature of the polyphenylene ether to 360°C or lowerg; and (3) at a temperature lower than the glass transition temperature of the polyphenylene ether in a solution, though not limited thereto. Although any one of the methods may be employed, the method (1) or (2) is preferred from the viewpoint of productivity.

The modifying compound for use in manufacturing a modified polyphenylene ether, having at least one carbon-to-carbon double or triple bond in the molecular structure and at least any one selected from the group consisting of a carboxylic group, an acid anhydride group, an amino group, a hydroxyl group, and a glycidyl group, is described in the following (hereinafter simply referred to as "modifying compound" in some cases).

Examples of the modifying compound having a carbon-to-carbon double bond together with a carboxylic acid group or an acid anhydride group in the molecule include maleic acid, fumaric acid, chloromaleic acid, cis-4-cyclohexene-1,2-dicarboxylic acid, and an acid anhydride thereof, though not limited thereto.

Fumaric acid, maleic acid and maleic acid anhydride are preferred, and fumaric acid and maleic acid anhydride are more preferred from the viewpoint of the reactivity with a polyphenylene ether resin, in particular.

Further, a compound which is the unsaturated dicarboxylic acids, their one or two of the two carboxylic groups may be esterified can use as the modifying compound.

Examples of the modifying compound having a carbon-to-carbon double bond together with a glycidyl group in the molecule include allyl glycidyl ether, glycidyl acrylate, glycidyl methacrylate, and an epoxidized natural oil and fat, though not limited thereto. Among these, glycidyl acrylate and glycidyl methacrylate are preferred.

Examples of the modifying compound having a carbon to carbon double bond together with a hydroxyl group in the molecule include an unsaturated alcohol represented by a general formula $C_nH_{2n-1}OH$ or $C_nH_{2n-3}OH$ (n: a positive integer) and an unsaturated alcohol represented by a general formula $C_nH_{2n-5}OH$ or $C_nH_{2n}$-$_7OH$ (n: a positive integer) such as allyl alcohol, 4-penten-1-ol, and 1,4-pentadien-3-ol, though not limited thereto.

One modifying compound may be used alone, or two or more thereof may be used in combination.

With an amount of the modifying compound to be added in manufacturing of a modified polyphenylene ether 0.1 parts by mass or more based on 100 parts by mass of the polyphenylene ether, the effect of modification on the polyphenylene ether is easily appeared, and with an amount of 10 parts by mass or less, side effects of the modification are hardly occurred. Accordingly, from the viewpoint of efficiency of the modification, the amount is preferably 0.1 to 10 parts by mass, more preferably 0.3 to 5 parts by mass, further more preferably 0.5 to 3 parts by mass, based on 100 parts by mass of the polyphenylene ether.

In manufacturing the modified polyphenylene ether using a radical initiator, a high modification efficiency can be achieved with an amount of the radical initiator added of 0.001 parts by mass or more based on 100 parts by mass of polyphenylene ether. Since the modified polyphenylene ether is hardly decomposed into low molecules with an amount of 1 part by mass or less, the amount is preferably 0.001 to 1 part by mass, more preferably 0.01 to 0.5 parts by mass, furthermore preferably 0.05 to 0.3 parts by mass, based on 100 parts by mass of polyphenylene ether, from the viewpoints of the modification ratio and the balance of physical properties.

The addition ratio of a modifying compound to the modified polyphenylene ether is preferably 0.01 to 5 % by mass, more preferably 0.05 to 3 % by mass, furthermore preferably 0.1 to 1 % by mass, based on 100 % by mass of

the modified polyphenylene ether.

The unreacted modifying compound and/or a polymer of the modifying compound in an amount of less than 5 % by mass, preferably 3 % by mass or less, more preferably 1 % by mass or less, may remain in the modified polyphenylene ether.

<Styrene-based resin (A-2)>

The component (A) contained in the flame retardant resin composition of the present embodiment is the above-mentioned polyphenylene ether resin (A-1) or a mixture of the above-mentioned polyphenylene ether resin (A-1) and a styrene-based resin (A-2) (hereinafter referred to as component (A-2) in some cases).

The styrene-based resin (A-2) is a copolymer obtained by polymerization of a styrene-based compound or a styrene compound and a compound that is copolymerizable with the styrene compound in presence or absence of a rubber polymer.

Examples of the styrene compound include styrene, $\alpha$-methylstyrene, 2,4-dimethylstyrene, monochlorostyrene, p-methylstyrene, p-tert-butylstyrene, and ethylstyrene, though not limited thereto. Among them, styrene is preferred.

Examples of the compound copolymerizable with the styrene compound include methacrylate esters such as methyl methacrylate and ethyl methacrylate, unsaturated nitrile compounds such as acrylonitrile and methacrylonitrile, and acid anhydride such as maleic anhydride, though not limited thereto.

The amount used of the compound copolymerizable with the styrene compound is preferably 20 mass% or less, more preferably 15 mass% or less, based on the total 100 mass% of the compounds copolymerizable with the styrene compound.

Examples of the rubber polymer include a conjugated diene rubber, a copolymer of a conjugated diene and an aromatic vinyl compound, and an ethylene-propylene copolymer rubber, though not limited thereto.

Specifically, polybutadiene and a styrene-butadiene copolymer are preferred.

In the case of using an unsaturated rubber polymer, a partially hydrogenated polybutadiene having a degree of unsaturation of 80 to 20% or a polybutadiene having 90% or more of the 1,4-cis bond is preferably used.

Examples of the styrene-based resin (A-2) include a homopolystyrene, a rubber-modified polystyrene (HIPS), a styrene-acrylonitrile copolymer (AS resin), a styrene-rubber polymer-acrylonitrile copolymer (ABS resin), and other styrene copolymers, though not limited thereto.

A homopolystyrene and a rubber-modified polystyrene (HIPS) are preferred as styrene-based resin (A-2), from the viewpoint of the compatibility with the polyphenylene ether resin.

In order to produce sufficient flame retardance, the flame retardant resin composition of the present embodiment includes the polyphenylene ether resin (A-1) and the styrene resin (A-2) with a mass ratio range of 70 to 100 % by mass of the polyphenylene ether resin (A-1) and 30 to 0 % by mass of the styrene resin (A-2), based on 100 % by mass of the total of both.

In order to obtain a flame retardant resin composition particularly excellent in flame retardance, the polyphenylene ether resin (A-1) in the range of 80 to 100 % by mass and the styrene-based resin (A-2) in the range of 20 to 0 % by mass are preferred, and the polyphenylene ether resin (A-1) in the range of 90 to 100 % by mass and the styrene resin (A-2) in the range of 10 to 0 % by mass are more preferred.

(Hydrogenated block copolymer (B))

The flame retardant resin composition of the present embodiment contains a hydrogenated block copolymer (B) (referred to as component (B) or (B) in some cases).

The hydrogenated block copolymer (B) for use in the present embodiment is a hydrogenated block copolymer which is obtained by hydrogenation of a block copolymer of an aromatic vinyl compound and a conjugated diene compound, for example, a block copolymer of styrene and a conjugated diene compound, i.e. a block copolymer including a polystyrene block and a conjugated diene compound polymer block.

The hydrogenation ratio of the unsaturated bonds derived from the conjugated diene compound by the hydrogenation is preferably 60% or more, more preferably 80% or more, furthermore preferably 95% or more, from the viewpoint of heat resistance stability.

In the case of the block copolymer of styrene and a conjugated diene compound, examples of the structure of the block copolymer before hydrogenation include S-B-S, S-B-S-B, $(S\text{-}B\text{-})_4$-Si and S-B-S-B-S, wherein S represents a styrene block chain and B represents a diene compound block chain.

The microstructure of the diene compound polymer block may be optionally selected.

The amount of the vinyl bonds (total of the 1,2-vinyl bond and the 3, 4-vinyl bond) of the conjugated diene compound polymer block is preferably 2 to 60%, more preferably in the range of 8 to 40%, relative to the amount of the total bonds (total of the 1,2-vinyl bond, the 3,4-vinyl bond, and the 1,4-conjugated bond)of the diene compound polymer.

The number average molecular weight of the hydrogenated block copolymer (B) is preferably 100,000 to 400,000, more preferably 150,000 to 350,000, furthermore preferably 200,000 to 300,000.

With a number average molecular weight of the hydrogenated block copolymer (B) of 100,000 or more, a flame retardant resin composition excellent in impact resistance can be obtained.

The impact resistance of the flame retardant resin composition of the present embodiment increases in proportion to the number average molecular weight of the hydrogenated block copolymer, and with a number average molecular weight of the hydrogenated block copolymer (B) of 400,000 or less, a flame retardant resin composition excellent in processing fluidity with a low load during melt extrusion can be obtained, allowing the hydrogenated block copolymer (B) to have excellent dispersibility into the flame retardant resin composition.

In the case of the hydrogenated block copolymer (B) having styrene polymer block chains, at least one styrene polymer block chain has a number average molecular weight of preferably 15, 000 or more, more preferably 20,000 or more and 50,000 or less. Furthermore preferably all the styrene polymer block chains have a number average molecular weight of 15,000 or more.

In the case of the hydrogenated block copolymer (B) having styrene polymer block chains, the proportion of the styrene polymer block chain in the hydrogenated block copolymer (B) is preferably 10 to 70 % by mass, more preferably 20 to 50 % by mass, furthermore preferably 30 to 40 mass%, from the viewpoint of impact resistance, though not particularly limited as long as the styrene polymer block chain has a number average molecular weight in the above-mentioned range.

Two or more hydrogenated block copolymers having a different composition or structure may be used in combination as hydrogenated block copolymer (B).

Examples thereof include a combination use of a hydrogenated block copolymer having a bonded styrene polymer content of 50 % by mass or more and a hydrogenated block copolymer having a bonded styrene polymer block content of 30 % by mass or less, a combination use of hydrogenated block copolymers having a different molecular weight from each other, and a combination use of the above-mentioned block copolymer which contains styrene and a conjugated diene and a hydrogenated random block copolymer obtained by hydrogenation of a block copolymer which contains a random copolymer block of styrene and a conjugated diene.

The "bonded styrene polymer block content" means the proportion of styrene polymer block chains in the hydrogenated block copolymer (B).

The hydrogenated block copolymer (B) has a Li (lithium) content of preferably 100 ppm or less as residual metal content. With a Li content of 100 ppm or less, the flame retardant resin composition of the present embodiment excellent in the long-term resistance to heat aging properties and the flame retardance after heat aging can be obtained.

From the same viewpoint, the hydrogenated block copolymer (B) has a Li content of more preferably 50 ppm or less, furthermore preferably 20 ppm or less.

The Li content can be measured by an ICP-AES method using iCAP6300 Duo manufactured by Thermo Fisher Scientific K.K., after a dry ashing pretreatment, i.e. heat treatment of a weighted sample in a crucible at 500 to 600°C for 5 to 20 minutes using a burner, an electric oven, or the like.

The flame retardant resin composition of the present embodiment has a hydrogenated block copolymer (B) content in the range of 1 to 30 parts by mass, preferably 2 to 25 parts by mass, more preferably 5 to 20 parts by mass, relative to 70 to 99 parts by mass of the above-mentioned component (A).

With a hydrogenated block copolymer (B) content of 1 part by mass or more, the resultant flame retardant resin composition of the present embodiment excellent in impact resistance can be obtained, and with a content of 30 parts by mass or less, the resultant flame retardant resin composition excellent in compatibility with the polyphenylene ether resin (A) and having high impact resistance with excellent rigidity such as flexural elastic modulus and bending strength can be obtained.

The hydrogenated block copolymer (B) is dispersed in a particulate form in the flame retardant resin composition of the present embodiment, having an average particle diameter of preferably 0.1 to 3 $\mu$m, more preferably 0.2 to 2.0 $\mu$m, furthermore preferably 0.3 to 1.0 $\mu$m.

With an average particle diameter of the hydrogenated block copolymer (B) in the range from 0.1 $\mu$m to 3.0 $\mu$m, the flame retardant resin composition of the present embodiment has excellent impact resistance.

The above-mentioned average particle diameter means a weight average particle diameter as described below.

The method for measuring the average particle diameter of the hydrogenated block copolymer (B) dispersed in the flame retardant resin composition of the present embodiment is described as follows.

An applicable method includes the successive steps of making a tensile test piece in accordance with ISO-15103, making an ultrathin slice from the tensile test piece, dyeing the ultrathin slice with ruthenium tetroxide to be photographed by a transmitting electron microscope, and calculating the weight average particle diameter using the photograph.

Specifically, an ultrathin slice is made from a test piece formed from the flame retardant resin composition of the present embodiment, and the ultrathin slice is dyed with ruthenium tetroxide to be photographed by a transmitting

electron microscope.

Using a transmitting electron micrograph at a magnification of 25,000, each particle diameter of the hydrogenated block copolymer (B) dispersed in the test piece of the flame retardant resin composition is measured, and the weight average particle diameter is calculated as follows.

On this occasion, since the dispersed particles have irregular shapes, circles each corresponding to the dispersed particles are described and the particle diameter can be substituted with the diameter of the circle to be read.

In a specific example, dispersed particles having a diameter of 1 mm or more in the photograph at a magnification of 25,000 are counted, with ranges to be read of 1 to 2 mm, 2 to 3 mm, 3 to 5 mm, 5 to 7 mm, 7 to 10 mm, 10 to 14 mm, 14 to 18 mm, and 18 to 22 mm.

The central diameter (Di) for the respective ranges to be read corresponds to 0.06 μm, 0.10 μm, 0.16 μm, 0.24 μm, 0.34 μm, 0.48 μm, 0.64 μm, and 0.80 μm.

From the central diameter (Di) for the ranges to be read and the number of pieces (Ni), the weight average particle diameter can be calculated based on the following formula.

$$\text{Weight average particle diameter } (\mu m) = \Sigma[(Di)^4 \times (Ni)]/\Sigma[(Di)^3 \times (Ni)]$$

(Phosphorus-containing flame retardant (C))

The flame retardant resin composition of the present embodiment contains a phosphorus-containing flame retardant (C) (referred to as component (C) or (C) in some cases).

The phosphorus-containing flame retardant (C) contains a phosphate ester compound (C-1) and a specified phosphinate salt (C-2).

The content of the phosphorus-containing flame retardant (C) is in the range from 5 to 30 parts by mass, preferably in the range from 10 to 25 parts by mass, furthermore preferably 15 to 20 parts by mass, based on 100 parts by mass of the total of the component (A) and the component (B), though different depending on the required level of flame retardance.

With a phosphorus-containing flame retardant (C) content of 5 parts by mass or more based on 100 parts by mass of the total of the component (A) and the component (B), the flame retardant resin composition of the present embodiment can obtain excellent flame retardance, and with 30 parts by mass or less, the composition can obtain excellent heat resistance.

<Phosphate ester compound (C-1)>

A phosphate ester compound (C-1) is added to improve flame retardance.

Any one of organic phosphate esters for general use as flame retardants may be used as phosphate ester compound (C-1).

Examples of the phosphate ester compound (C-1) include triphenyl phosphate, trisnonylphenyl phosphate, resorcinolbis(diphenylphosphate), resorcinolbis[di(2,6-dimethylphenyl)phosphate], 2,2-bis{4-[bis(phenoxy)phosphoryloxy]phenyl}propane, and 2,2-bis{4-[bis(methylphenoxy)phosphoryloxy]phenyl}propane, though not limited thereto.

In addition to the above, examples of the phosphate ester (C-1) flame retardant include: a phosphate ester flame retardant such as trimethyl phosphate, triethyl phosphate, tributyl phosphate, trioctyl phosphate, tributoxyethyl phosphate, tricresyl phosphate, cresyl phenyl phosphate, octyl diphenyl phosphate, and diisopropyl phenyl phosphate; a monophosphate ester compound such as diphenyl-4-hydroxy-2,3,5,6-tetrabromobenzyl phosphonate, dimethyl-4-hydroxy-3,5-dibromobenzyl phosphonate, diphenyl-4-hydroxy-3,5-dibromobenzyl phosphonate, tris(chloroethyl) phosphate, tris(dichloropropyl) phosphate, tris(chloropropyl) phosphate, bis(2,3-dibromopropyl)-2,3-dichloropropyl phosphate, tris(2,3-dibromopropyl) phosphate, bis(chloropropyl) monooctyl phosphate, hydroquinonyl diphenyl phosphate, phenyl nonylphenyl hydroquinonyl phosphate and phenyl dinonylphenyl phosphate; and aromatic condensed phosphate ester compounds.

Among these, aromatic condensed phosphate ester compounds are preferred, having excellent thermal stability and the like with less gas generation during processing.

The aromatic condensed phosphate ester compounds are commercially available, and examples thereof include CR741, CR733S and PX200 manufactured by Daihachi Chemical Industry Co., Ltd., and FP600, FP700 and FP800 manufactured by ADEKA Corporation, though not limited thereto.

The phosphate ester (C-1) for use in the present embodiment is preferably a phosphate ester represented by the following general formula (III) or the following general formula (IV).

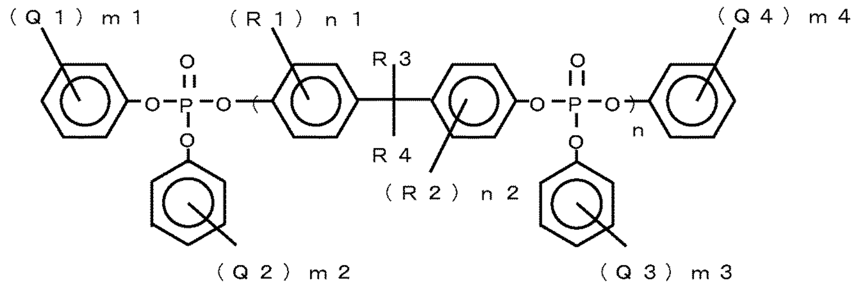

・・・(III)

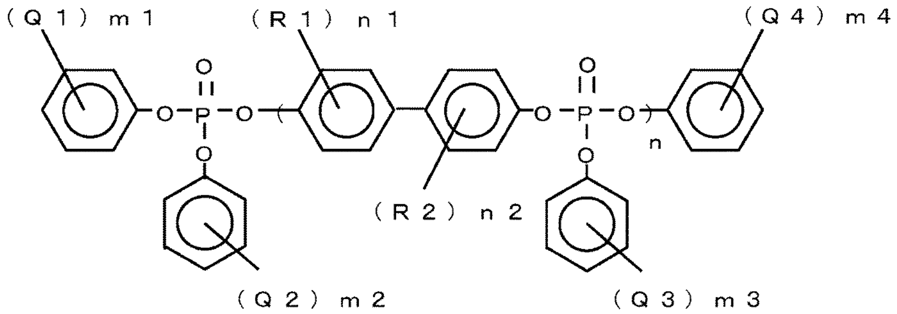

・・・(IV)

In the general formulas (III) and (IV), Q1, Q2, Q3 and Q4 each independently represent an alkyl group having 1 to 6 carbon atoms, R1 and R2 represent a methyl group, and R3 and R4 each independently represent a hydrogen atom or a methyl group; n is an integer of 1 or more, n1 and n2 each independently represent an integer of 0 to 2, and m1, m2, m3 and m4 each independently represent an integer of 0 to 3.

In each molecule of the phosphate ester compounds represented by the general formulas (III) and (IV), n is an integer of 1 or more, preferably an integer of 1 to 3.

Among the phosphate ester compounds represented by the general formulas (III) and (IV), a condensed phosphate ester represented by the general formula (III), wherein m1, m2, m3, m4, n1 and n2 are 0, and R3 and R4 each represent a methyl group, is preferred.

Preferred examples also include condensed phosphate esters represented by the general formula (III), wherein Q1, Q2, Q3, Q4, R3 and R4 each represent a methyl group, n1 and n2 are 0, and m1, m2, m3 and m4 each represent an integer of 1 to 3, containing 50 mass% or more of a phosphate ester having n in the range of 1 to 3, in particular, 1.

Among these condensed phosphate ester compounds, condensed phosphate ester compounds having an acid value of 0.1 or less (a value obtained in accordance with JIS K2501) are more preferred.

<Phosphinate salt (C-2)>

The flame retardant resin composition of the present embodiment contains a specified phosphinate salt (C-2) as phosphorus-containing flame retardant (C).

The phosphinate salt (C-2) is at least one selected from the group consisting of a phosphinate salt represented by the following general formula (I), a diphosphinate salt represented by the following general formula (II), and a condensate thereof.

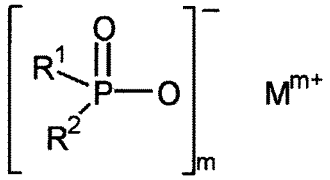

(I)

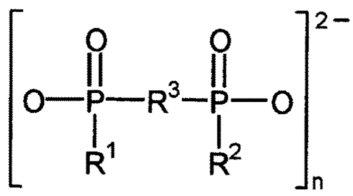 (II)

In the general formulas (I) and (II), $R^1$ and $R^2$ are a linear or branched C1-C6 alkyl group or a C6-C10 aryl group and may be the same or different from each other.

$R^3$ is any one selected from the group consisting of a linear or branched C1-C10 alkylene group, a C6-C10 arylene group, a C6-C10 alkyl arylene group, and a C6-C10 aryl alkylene group.

M is one or more selected from the group consisting of a calcium ion, a magnesium ion, an aluminum ion, a zinc ion, a bismuth ion, a manganese ion, a sodium ion, a potassium ion, and a cationized nitrogen base; m is 1, 2, or 3, n is 1 to 3, x is 1 or 2, and 2n=mx.

The phosphinate salt, the diphosphinate salt, and the condensate thereof for use as component (C-2) in the present embodiment (hereinafter referred to as phosphinate salts in some cases) can be manufactured by a known method described in European Patent Publication No. 699708 or Japanese Patent Laid-Open No. 08-73720.

Examples of the method for manufacturing the phosphinate salts (C-2) include reacting a phosphinic acid with a metal carbonate, a metal hydroxide, or a metal oxide in an aqueous solution, though not limited thereto. Alternatively, the phosphinate salts (C-2) may be manufactured by a sol-gel method or the like.

The phosphinate salts typically include monomer compounds, and may include oligomer phosphinate salts having a degree of condensation of 1 to 3 depending on the environment under reaction conditions.

Examples of the phosphinic acid to constitute the phosphinate salts (C-2) include dimethylphosphinic acid, ethylmethylphosphinic acid, diethylphosphinic acid, methyl-n-propylphosphinic acid, methanedi(methylphosphinic acid), benzene-1,4-(dimethylphosphinic acid), methylphenylphosphinic acid, diphenylphosphinic acid, and a mixture thereof, though not limited thereto.

Examples of the metal ion component to constitute M in the formulas (I) and (II) of the phosphinate salts (C-2) include one or more selected from the group consisting of a calcium ion, a magnesium ion, an aluminum ion, a zinc ion, a bismuth ion, a manganese ion, a sodium ion, a potassium ion, and a cationized nitrogen base, and preferably one or more selected from a calcium ion, a magnesium ion, an aluminum ion, and a zinc ion from the viewpoint of thermal stability.

Examples of the cationized nitrogen base include a cationized base such as ammonia, melamine and triethanolamine.

Examples of the phosphinate salts (C-2) include calcium dimethylphosphinate, magnesium dimethylphosphinate, aluminum dimethylphosphinate, zinc dimethylphosphinate, calcium ethylmethylphosphinate, magnesium ethylmethylphosphinate, aluminum ethylmethylphosphinate, zinc ethylmethylphosphinate, calcium diethylphosphinate, magnesium diethylphosphinate, aluminum diethylphosphinate, zinc diethylphosphinate, calcium methyl-n-propylphosphinate, magnesium methyl-n-propylphosphinate, aluminum methyl-n-propylphosphinate, zinc methyl-n-propylphosphinate, calcium methanedi(methylphosphinate), magnesium methanedi(methylphosphinate), aluminum methanedi(methylphosphinate), zinc methanedi(methylphosphinate), calcium benzene-1,4-(dimethylphosphinate), magnesium benzene-1,4-(dimethylphosphinate), aluminum benzene-1,4-(dimethylphosphinate), zinc benzene-1,4-(dimethylphosphinate), calcium methylphenylphosphinate, magnesium methylphenylphosphinate, aluminum methylphenylphosphinate, zinc methylphenylphosphinate, calcium diphenylphosphinate, magnesium diphenylphosphinate, aluminum diphenylphosphinate, and zinc diphenylphosphinate, though not limited thereto.

In particular, calcium dimethylphosphinate, aluminum dimethylphosphinate, zinc dimethylphosphinate, calcium ethylmethylphosphinate, aluminum ethylmethylphosphinate, zinc ethylmethylphosphinate, calcium diethylphosphinate, aluminum diethylphosphinate, and zinc diethylphosphinate are preferred, from the viewpoints of flame retardance and suppression of mold deposit.

The component (C-2) has an average particle diameter (d50%) of preferably 0.2 μm or more and less than 40 μm, more preferably more than 0.5 μm and 30 μm or less, further preferably more than 0.5 μm and 20 μm or less, and furthermore preferably more than 1.0 μm and 10 μm or less.

Examples of the method for obtaining particles of the component (C-2) having an average particle diameter in the range include dispersing lumps of the phosphinate salt having a particle diameter in the range or larger in a specified solvent so as to be wet-milled and classified, though not limited thereto.

In particular, use of fine particles having an average particle diameter of more than 0.5 μm and 20 μm or less is preferred, allowing the flame retardant resin composition of the present embodiment to have not only more enhanced flame retardance but also drastically improved impact resistance, fluidity and appearance of a molded product.

In the flame retardant resin composition of the present embodiment, the particle diameter distribution of the

component (C-2) has a ratio (d75%/d25%) of the particle diameter at 75% of cumulative particle size distribution from the fine end (d75%) to the particle diameter at 25% (d25%) of preferably more than 1.0 and 5.0 or less, more preferably 1.2 to 4.0, furthermore preferably 1.5 to 3.0.

Use of the phosphinate salt having a (d75%/d25%) value of more than 1.0 and 5.0 or less as component (C-2) allows the flame retardant resin composition of the present embodiment to have a drastically improved surface impact resistance.

The average particle diameter (d50%) and the particle diameter distribution are based on the volume-based particle diameter measured by a laser diffraction/scattering particle size distribution measuring device, using a 3% isopropanol aqueous solution as dispersion medium of the phosphinate salt.

Specifically, using a laser diffraction/scattering particle size distribution measuring device LA-910 (manufactured by Horiba, ltd.), a dispersion medium of 3% isopropanol aqueous solution is subjected to a blank measurement, and a measurement sample is then put in to have a specified transmittance (95% to 70%) for the measurement.

The dispersion of the sample in the dispersion medium is performed by irradiation of ultrasonic waves for 1 minute.

The phosphinate salts (C-2) for use in the present embodiment may contain residual unreacted materials or by-products if not to impair the effect of the present invention.

The phosphorus-containing flame retardant (C) of the present embodiment has a mass ratio (C-1) / (C-2) of the phosphate ester compound (C-1) to the phosphinate salt (C-2) of 50/50 to 70/30.

With a mass ratio (C-1)/(C-2) of 50/50 to 70/30, the flame retardance after heat aging is improved and a flame retardant resin composition excellent in appearance and impact resistance can be obtained.

(Titanium oxide (D))

The thermoplastic resin composition for use in the present embodiment may further contain titanium oxide (D) (hereinafter referred to as component (D) or (D) in some cases).

The inclusion of the titanium oxide (D) improves the heat resistance stability, so that the flame retardance after heat aging is improved.

The component (D) content in the flame retardant resin composition of the present embodiment is preferably 0.1 to 5.0 % by mass, more preferably 0.3 to 3.0 % by mass, furthermore preferably 0.5 to 1.5 % by mass.

With a component (D) content of 0.1 % by mass or more, the flame retardance after heataging is improved, and with a content of 5.0 % by mass or less the impact strength can be secured.

The primary particle diameter of the titanium oxide (D) is preferably 0.01 to 0.5 μm, more preferably 0.02 to 0.4 μm, and more preferably 0.05 to 0.3 μm, from the viewpoints of the balance between dispersibility and handling properties in manufacturing.

The titanium oxide (D) may contain at least one of hydrous oxides and/or oxides of aluminum, magnesium, zirconia titanium, tin, or the like, salts of a higher fatty acid such as stearic acid, and organic silicon compounds as a surface treatment agent.

The titanium oxide (D) may be manufactured by a dry method or a wet method.

Although the crystal structure of the titanium oxide (D) may be any one of a rutile type and an anatase type, a rutile type is preferred from the viewpoint of thermal stability of the thermoplastic resin composition for use in the present embodiment.

(Inorganic filler)

The flame retardant resin composition of the present embodiment preferably contains no inorganic filler from the viewpoints of the flame retardance and the flame retardance after heat aging.

In particular, in the case of using the flame retardant resin composition in the present embodiment as a material of a photovoltaic power generation module connection structure, preferably no inorganic filler is contained from the viewpoints of resistance to heat aging and impact strength.

In the case of the flame retardant resin composition of the present embodiment containing inorganic filler, the inorganic filler content is preferably 5.0% by mass or less, more preferably 3.0 % by mass or less, furthermore preferably none substantially.

Examples of the inorganic filler include inorganic reinforcing material in a fibrous form, a granular form, a tabular form, or an acicular form such as glass fiber, potassium titanate fiber, gypsum fiber, brass fiber, stainless fiber, steel fiber, ceramic fiber, boron whisker fiber, mica, talc, silica, kaolin, calcined kaolin, wollastonite, xonotlite, apatite, glass beads, flake glass, and carbon black for coloring, though not limited thereto.

One inorganic filler may be used alone, or two or more thereof may be used in combination.

The inorganic filler for use may be surface treated by a known method using a surface treatment agent such

as silane coupling agent.

(Other components)

<Oil>

The flame retardant resin composition of the present embodiment may contain specified components other than the components (A) to (C), and titanium oxide (D) and inorganic filler which are added on an as needed basis.
Examples of the other components include oil.
The oil means an inorganic or organic oil and fat in a liquid form at 30°C.
The oil may be any one of a synthetic oil, a mineral oil, an animal oil, a vegetable oil, and the like.
Specific examples include vegetable oil such as soybean oil and flaxseed oil, and oil for heating medium represented by a naphthene oil, a paraffin oil, an aromatic oil and benzyltoluene. In particular, a naphthene oil, a paraffin oil, and an aromatic oil are preferred and a paraffin oil is more preferred.
These oils are typically a mixture of three components including an aromatic ring, a naphthene ring and a paraffin chain. The oil having a carbon number ratio of the paraffin chain of 50% or more relative to the total carbons in the mixture is referred to as paraffin oil, the oil having a carbon number ratio of the naphthene ring of 30 to 45% is referred to as naphthene oil, and the oil having a carbon number ratio of the aromatic ring of more than 30% is referred to as aromatic oil.
More particularly, the paraffin oil is a mixture of hydrocarbon compounds with a number average molecular weight in the range of 100 to 10,000 including the three, i.e. an aromatic ring-containing compound, a naphthene ring-containing compound, and a paraffin compound, having a paraffin compound content of 50 % by mass or more.
More specifically, the paraffin oil includes a combination of 50 to 90 % by mass of paraffin compounds, 10 to 40 % by mass of naphthene ring-containing compounds, and 5 % by mass or less of aromatic ring-containing compounds, having a number average molecular weight in the range from 100 to 2000, preferably in the range from 200 to 1,500.
The paraffin oil is commercially available, and examples thereof include DIANA PROCESS OIL PW-380 (manufactured by Idemitsu Kosan Co., Ltd.), though not limited thereto.
The method for adding the oil to the flame retardant resin composition of the present embodiment is not particularly limited. For example, the oil in a liquid form may be added to the flame retardant resin composition during melt kneading, or the oil may be premixed with the above-mentioned hydrogenated block copolymer (B). In particular, the method of premixing the oil with the hydrogenated block copolymer (B) is preferred. On this occasion, the amount of oil is preferably less than 70 parts by mass, more preferably less than 60 parts by mass, based on 100 parts by mass of the hydrogenated block copolymer (B) .

<Flame retardant other than component (C)>

The flame retardant resin composition of the present embodiment may further contain a flame retardant other than the above-mentioned components (C).
The flame retardant other than the (C) is preferably an inorganic or organic flame retardant which contains substantially no halogen.
Examples of the flame retardant other than the (C) include a known inorganic flame retardant such as magnesium hydroxide and aluminum hydroxide; a phosphoric acid-based nitrogen-containing compound such as ammonium polyphosphate, melamine polyphosphate, melem polyphosphate, melam polyphosphate, and melon polyphosphate; a phosphazene compound as described in Japanese Patent Laid-Open No. 11-181429; a cyclic nitrogen compound such as melon and melem; silicone oil, red phosphorus, zinc borate, and other known flame retardants, though not limited thereto.

<Anti-dripping agent>

The flame retardant resin composition of the present embodiment may contain a fluorine polymer represented by, for example, tetrafluoroethylene as anti-dripping agent.
The fluorine polymer content is preferably less than 2 % by mass in the flame retardant resin composition of the present embodiment.

<Thermoplastic elastomer>

An olefin-based thermoplastic elastomer including a polyolefin such as polyethylene and polypropylene, an ethylene-propylene copolymer, an ethylene-butylene copolymer, and an ethylene-octene copolymer may further be

added to the flame retardant resin composition of the present embodiment.

The releasability from a mold can be thereby improved.

The olefin-based thermoplastic elastomer is preferably used, in particular, in combination with a block copolymer including a polymer block mainly composed of an aromatic vinyl compound and a polymer block mainly composed of a conjugated diene compound.

The amount of the olefin-based thermoplastic elastomer is preferably 0.1 to 10 % by mass, more preferably 0.5 to 5 % by mass, furthermore preferably 1.0 to 3.0 % by mass, based on 100 % by mass of the flame retardant resin composition of the present embodiment.

Additional components other than the above-mentioned components may be added to the flame retardant resin composition of the present embodiment on an as needed basis within a range not to impair the effect of the present invention, in an arbitrary stage.

Examples of the additional components include a plasticizer (e.g. low-molecular weight polyolefins, polyethylene glycol, and fatty acid esters), an antistatic agent, a nucleating agent, a fluidity modifier, a filler, a reinforcing agent, various peroxides, a spreading agent, a copper-based thermal stabilizer, an organic thermal stabilizer represented by a hindered phenol-based oxidative degradation inhibitor, antioxidant, a UV absorber, and a light stabilizer, though not limited thereto.

The specific amount of each of the components added is preferably 10 % by mass or less, more preferably less than 5 % by mass, furthermore preferably 3 % by mass or less in the flame retardant resin composition.

[Method for manufacturing flame retardant resin composition]

The flame retardant resin composition of the present embodiment can be manufactured by mixing the above-mentioned components (A) to (C), and the above-mentioned titanium oxide (D), an inorganic filler, and various other components on an as needed basis using a specified processing machine.

Examples of the specific processing machine for manufacturing the flame retardant resin composition of the present embodiment include a monoaxial extruder, a biaxial extruder, a roll, a kneader, a Brabender plastograph, and a banbury mixer, though not limited thereto. Among them, a biaxial extruder is preferred, and a biaxial extruder having an upstream supply port and one or more downstream supply ports is more preferred.

The melt kneading temperature for obtaining the flame retardant resin composition of the present embodiment is not particularly limited, and can be arbitrarily selected from the range of 240 to 360°C to achieve the suitable conditions for the flame retardant resin composition, considering the kneading state and the like.

The thus obtained flame retardant resin composition can be processed into various molded components by various conventionally known methods such as injection molding and extrusion molding.

[Properties of flame retardant resin composition]

The flame retardant resin composition of the present embodiment is excellent in resistance to heat aging . Specifically, the increasing ratio of the residue amount relative to the residue amount of an injection molded product of the flame retardant resin composition having a thickness of 1.5 mm obtained by thermogravimetric analysis (measurement conditions: temperature rising from room temperature to 700°C at a heating rate of 20°C/min under nitrogen atmosphere) using a thermogravimeter, and the residue amount of an injection molded product of the flame retardant resin composition having a thickness of 1.5 mm obtained by the thermogravimetric analysis after heat aging under conditions at 150°C for 500 hours, is preferably 12% or less.

With a increasing retio of the residue amount of 12% or less, the effect for suppressing reduction in flame retardance after heat aging can be obtained.

The increasing ratio of the residue amount can be suppressed by using a phosphate ester compound (C-1) and phophinates (C-2) in combination, and can be measured by a method described in the following Examples. As the increasing ratio of the residue amount decreases, the more excellent resistance to heat aging can be obtained. Accordingly no specific lower limit is provided.

The increasing retio of the residue amount is more preferably 11% or less.

A molded product of the flame retardant resin composition of the present embodiment is excellent in flame retardance. Specifically, the injection molded product having a thickness of 1.5 mm has a flame retardance specified in the UL-94 standard in the range of V-1 or higher, more preferably in the range of V-0, after heat aging under conditions at 150°C for 500 hours.

As described above, the flame retardant resin composition of the present embodiment includes 70 to 99 parts by mass of a polyphenylene ether resin or a mixed resin of a polyphenylene ether resin and a styrene resin (A), 1 to 30 parts by mass of a hydrogenated block copolymer (B), and 5 to 30 parts by mass of a phosphorus-containing flame retardant (C) based on 100 parts by mass of the total of the component (A) and the component (B) . The phosphorus-containing flame retardant (C) includes a phosphate ester compound (C-1) and at least one selected from the group

consisting of a specified phosphinate salt, a specified diphosphinate salt, and a condensate thereof (C-2). Consequently the flame retardant resin composition has excellent heat resistance, mechanical properties, electrical properties, water resistance and chemical resistance in practical use, hardly causing problems such as fuming during injection molding and adhesion of the flame retardant to a mold, capable of effectively suppressing reduction in the flame retardance when exposed to a high-temperature environment for a long period.

[Application]

The flame retardant resin composition of the present embodiment can be used in applications in which heat resistance, flame retardance, and electrical properties are particularly important, capable of being suitably used as electrical/electronic components and electrical/electronic components for automobiles.

The electrical components can be used as internal parts of industrial equipment such as office machines, measuring instruments, chassis, and electrical instruments, power adaptors of home appliances, storage mediums and drives thereof, sensor instruments, terminal blocks, electrical/electronic components for use in secondary batteries, fuel cells and solar cells, solar thermal power generation, geothermal power generation, wind power generation, and smart meters in the fields of energy and environment, electrical components to constitute power transmission facilities, cable terminals, automobile components, and, in particular, connection structures for solar power generation modules such as module connectors for photovoltaic power generation and junction boxes for solar cells, and components for hybrid vehicles and electric vehicles.

With reference to Examples, the embodiments of the present invention are described in more details as follows.

Examples

Although the present invention is described in details as follows with reference to concrete Examples and Comparative Examples, the present invention is not limited to the following Examples.

The measurement methods and raw materials for use in Examples and Comparative Examples are described as follows.

[Measurement method]

(1) Flame retardance (UL-94)

Test pieces for flammable tests were molded from the resin compositions manufactured in Examples and Comparative Examples by an injection molding machine IS-100GN manufactured by Toshiba Machine Co., Ltd. (cylinder temperature set at 320°C, mold temperature set at 80°C) .

In accordance with the UL-94 standard, a vertical flammable test was performed using injection molded test pieces having a thickness of 1.5 mm.

Flame was applied to each of the 5 test pieces twice, for total 10 times, and the average number of seconds and the maximum number of seconds required for the flame extinction were measured for the test pieces each to be ranked.

(Rank)

In the measurement of burning time for a set of 5 test pieces, for total 10 times, test pieces having any measured burning time of 10 seconds or less with a total of the burning time for the ten times of 50 seconds or less, without occurrence of cotton ignition of drips were ranked as "V-0", test pieces having any measured burning time of 30 seconds or less with a total of the burning time for the ten times of 250 seconds or less, without occurrence of cotton ignition of drips were ranked as "V-1", and test pieces having any measured burning time of 30 seconds or less with a total of the burning time for the ten times of 250 seconds or less, with occurrence of cotton ignition of drips were ranked as "V-2", and test pieces below the evaluation criteria were ranked as "notV".

The flammability test results are shown in "Heat resistant aging properties 0hr" in Table 1 and Table 2".

(2) Resistance to heat aging

In accordance with the vertical flammable test specified in the UL-94 standard, an injection molded test pieces having a thickness of 1.5 mm were subjected to two kinds of heat aging for 300 hours and 500 hours in an air circulation oven set at 150°C, then left standing at room temperature (23°C), and a humidity of 50% for 24 hours, and then subjected to the flammable test in the same manner as in the above (1).

Flame was applied to each of the 5 test pieces twice, for total 10 times, and the average number of seconds and the maximum number of seconds required for the flame extinction were measured for the test pieces each to be ranked.

Test pieces which cannot be measured due to large deformation after heat aging were ranked "unmeasurable".

(3) Charpy impact strength

Pellets of the resin composition of Examples and Comparative Examples were dried at 100°C for 2 hours.

Test pieces were molded from the dried pellets of resin composition by an injection molding machine IS-100GN manufactured by Toshiba Machine Co., Ltd. (cylinder temperature set at 280°C, mold temperature set at 80°C), in accordance with ISO-15103.

In accordance with ISO-179, test pieces with a notch for the Charpy impact test were formed by scribing the notch at the center.

The Charpy impact strength of the sample pieces with a notch for the Charpy impact test was measured at 23°C in accordance with ISO-179, for evaluation of impact resistance.

(4) Appearance

Pellets of the resin composition of Examples and Comparative Examples were dried at 100°C for 2 hours.

Flat plates of 50 mm by 90 mm by 2.5 mm were molded from the dried pellets of resin composition by an injection molding machine IS-100GN manufactured by Toshiba Machine Co., Ltd. (cylinder temperature set at 280°C, mold temperature set at 80°C) . The surface roughness of the flat plate was visually observed and evaluated by the following criteria.

A surface having almost no roughened portion was rated as good, a surface having a few roughened portions as fair, and a surface having many roughened portions as bad.

(5) Mold deposit (MD)

In molding the UL-94 test pieces (thickness: 1.5 mm) from the pellets of resin composition of Examples and Comparative Examples dried at 80°C for 2 hours by an injection molding machine IS-100GN manufactured by Toshiba Machine Co., Ltd. (cylinder temperature set at 310°C, mold temperature set at 80°C), 30 shots of continuous molding were performed at a pressure to make approximately 1 cm short of full filling, after wiping the mold surface.

The presence or absence or the amount of the adhered solid substance formed at the molding cavity terminal end of a mold was then visually observed and evaluated by the following criteria.

A case with almost no adhered substance being observed was rated as good, a case with adhered substance being clearly observed as poor, and an intermediate case with a little adhered substance being observed as fair.

(6) Increasing ratio of residue amount

A test piece for use in the evaluation of flame retardance properties (UL-94) was prepared, and a test piece after heat aging was prepared by heat aging the above-mentioned test piece in an air circulation oven set at 150°C for 500 hours to be then left standing at room temperature (23°C) and a humidity of 50% for 24 hours.

A part of the central region (the region with 3 mm from the ends cut off) of each of the test pieces was shredded into small pieces of about 1 mg. About 5 mg of the pieces were weighed and the residue amount was measured by a thermogravimeter.

The measurement of the residue amount was performed by THERMO PLUS2 TG8120 manufactured by Rigaku Corporation under the following conditions: amount of test piece: about 5 mg, measurement region: room temperature to 700°C, rate of temperature rise: 20°C/min, atmosphere: nitrogen, and nitrogen flow rate: 200 ml/min. The residue sample weight (%) at 700°C was evaluated as the residue amount.

The increasing Ratio of the residue amount (%) was calculated from the following formula.

$$\text{Increasing Ratio of residue amount (\%)} = [(\text{residue amount of test piece after heat aging} - \text{residue amount of test piece before heat aging})/(\text{residue amount of test piece before heat aging})] \times 100$$

[Raw material]

(Polyphenylene ether resin and styrene-based resin (A))

(Polyphenylene ether resin (A-1) (hereinafter referred to as PPE)

Poly(2,6-dimethyl-1,4-phenylene ether) [product name: S201A, manufactured by Asahi Kasei Chemicals Corporation]

Styrene-based resin (A-2)

High impact polystyrene (hereinafter referred to as HIPS) [product name: PSJ POLYSTYRENE H9302, manufactured by PS Japan Corporation]

(Hydrogenated block copolymer (B))

Based on the below-mentioned method for manufacturing hydrogenated block copolymers and the method for reducing the amount of Li of hydrogenated block copolymers, the following hydrogenated block copolymers were obtained.

(B-1): residual amount of Li<1 ppm
(B-2): residual amount of Li=64 ppm

<Method for manufacturing hydrogenated block copolymer>

Styrene and butadiene were anion block copolymerized in a cyclohexane solution, using n-butyl lithium as polymerization catalyst and tetrahydrofuran as vinyl content adjusting agent. Subsequently, using bis(cyclopentadienyl)titanium dichloride and n-butyl lithium as hydrogenation catalysts, hydrogenation was performed at a hydrogen pressure of 5 kg/cm$^2$ at 50°C for 2 hours based on the method described in Japanese Patent Laid-Open No. 59-133203. Consequently 90% or more of the double bonds in the butadiene block portion were hydrogenated, and almost all the benzene rings in the styrene block portion remained without being hydrogenated.
As a result, a block copolymer having a styrene block content of 32 mass%, a weight average molecular weight of 260,000, and a hydrogenation ratio of 99% was manufactured. The residual Li amount was 100 ppm.
The polymer structure was controlled by changing the amount of monomers to be charged and the molecular weight was controlled by changing the amount of catalysts, respectively.
The styrene content was measured by a UV spectrophotometer, and the weight average molecular weight was measured by gel permeation chromatography.
The hydrogenation ratio was measured by a nuclear magnetic resonance apparatus (NMR).
The amount of residual Li was measured by ICP-AES.

<Operation for reducing Li of hydrogenated block copolymer>

[Operation for reducing Li of hydrogenated block copolymer (B-1)]

A cyclohexane solution (17 mass%) of the thus synthesized hydrogenated block copolymer (Li content: 100 ppm) and water in an amount of 0.5 times by volume of the solution were fed to a rotary disperser by a pump so as to be mixed.
A rotary disperser SUPRATON 200 (manufactured by Krupp (Germany), volume of mixing part: 30 cm$^3$) was used.

The rotary disperser is a high-speed rotary disperser having an engaging structure with a rotor/stator in a comb shape.

The mixing temperature was 60°C, the residence time of the polymer solution in the mixer was 1.0 sec, and the rotational speed of the rotary disperser was 7,600 rpm. On this occasion, the P/V value was $25\times10^4$ kw/m$^3$, and the circumferential speed was 28 m/s.

After processing by the rotary disperser, the mixture of the hydrogenated block copolymer solution and water was fed to a separation tank heated at 70°C. To the upper layer (hydrogenated block copolymer solution layer), 0.5 parts by mass of octadecyl-3-(3,5-di-tert-butyl-4-hydroxyphenyl)propionate was added to 100 parts by mass of the hydrogenated block copolymer to be mixed.

Subsequently, the following steam stripping was further performed.

In the steam stripping of the hydrogenated block copolymer, a mixture (poly (oxyethylene) oxyethylene unit: 9 to 10 on average) of dihydrodiene phosphate esters and monohydrodiene phosphate esters of $\alpha$-(p-nonylphenyl)-$\omega$-hydroxypoly(oxyethylene) in an amount of 30 ppm relative to water in the stripping zone was used as crumbing agent to remove the solvent at a temperature of 90 to 98°C.

Any slurry in a solvent removal tank had a polymer crumb concentration of about 5 % by mass.

Subsequently, the thus obtained aqueous dispersion slurry of a block copolymer in a crumb form was fed to a rotary screen, so as to obtain a hydrous crumb with a water content of about 45 mass%.

The hydrous crumb was fed to a monoaxial screw extruder-type water squeezer to obtain a dehydrated hydrogenated block copolymer (B-1).

The thus obtained hydrogenated block copolymer (B-1) had a residual Li amount of less than 1 ppm.

<Hydrogenated block copolymer (B-2)>

The cyclohexane solution (20 % by mass) of the thus synthesized hydrogenated block copolymer and water in an amount of 0.2 times by volume of the hydrogenated block copolymer solution were fed to a rotary disperser by a pump so as to be mixed.

A CAVITRON 1010 (manufactured by Nittetsu Mining Co., Ltd., volume of mixing part: 4 cm$^3$) was used as rotary disperser.

The rotary disperser is a high-speed rotary disperser having an engaging structure with a rotor/stator in a perforated shape.

Subsequently, a hydrogenated block copolymer (B-2) was obtained in the same manner as in the case of the hydrogenated block copolymer (B-1).

The thus obtained hydrogenated block copolymer (B-2) had a residual Li amount of 64 ppm.

(Phosphorus-containing flame retardant (C))

<Phosphonate ester compound (C-1)>

(FR-1)

Bisphenol A-based condensed phosphate ester "product name: CR-741, manufactured by Daihachi Chemical Industry Co., Ltd."

A phosphorus compound represented by the following formula, including a main component having n=1 (with an area ratio of about 85% in liquid chromatography analysis), with an acid value of 0.01.

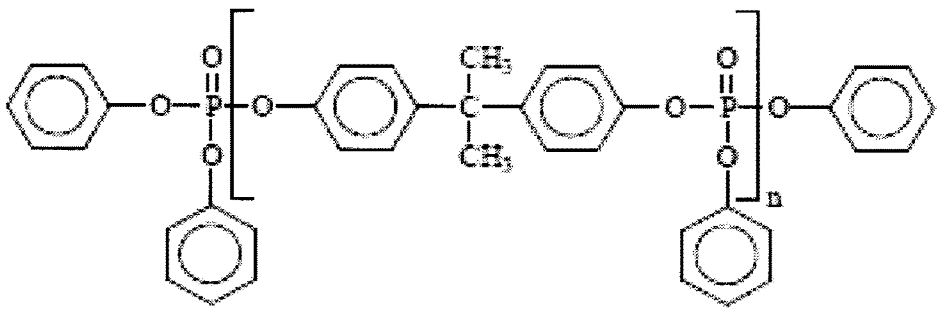

(FR-2)

Biphenyl-based condensed phosphate ester "product name: ADEKASTAB FP800 manufactured by ADEKA Corporation"

A phosphorus compound represented by the following formula, including a main component having N=1 (with an area ratio of about 85% in liquid chromatography analysis).

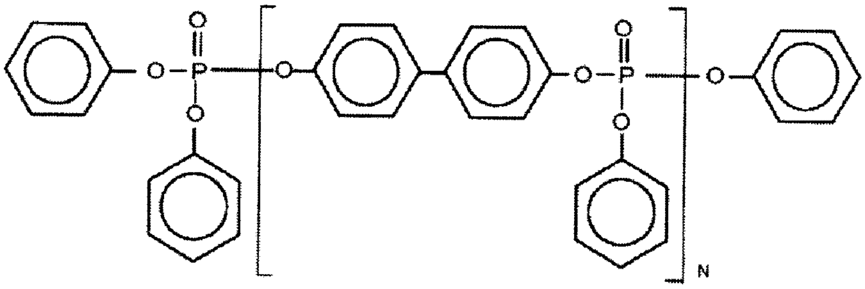

<Phosphinate salts (C-2)>

(FR-3)

Phosphinate salt "product name: EXOLIT OP 930, manufactured by Clariant K.K."
Average particle diameter: 3 μm

(FR-4)

Phosphinate salt "product name: EXOLIT OP 1230, manufactured by Clariant K.K."
Average particle diameter: 20 μm

(Other flame retardants)

(FR-5)

Nitrogen-containing flame retardant which contains an adduct composed of melamine and phosphoric acid;
Melamine polyphosphate [product name: MELAPUR 200/70, manufactured by BASF]

(FR-6)

Melamine cyanurate "Product name: MC 6000 manufactured by Nissan Chemical Industries Ltd."

(FR-7)

Magnesium hydroxide "product name: KISMA 5 manufactured by Kyowa Chemical Industry Co., Ltd."

(Titanium oxide (D))

(D-1)

Titanium oxide "product name: RT-C30 manufactured by Huntsman Corporation"

Average particle diameter: 0.2 μm

(Polyolefin (E))

(LDPE)

Low density polyethylene "product name: SUNTEC LD M2004, manufactured by Asahi Kasei Chemicals Corporation

(Thermal stabilizer (F))

(F-1)

Hindered phenol-based antioxidant "product name: IRGANOX 565, manufactured by BASF Japan Ltd."

(F-2)

Phosphite-based antioxidant "product name: IRGFOS 168, manufactured by BASF Japan Ltd."

[Examples 1 to 11] and [Comparative Examples 1 to 8]

A biaxial extruder [ZSK-26MC: manufactured by Coperion (Germany)] was used with a cylinder temperature set at 320°C at upstream and at 280°C at downstream.

With the blending ratios (parts by mass) shown in the following Table 1 and Table 2, the component (A), the component (B), the component (C), and the components other than the components (A) to (C) were supplied from an upstream supply port.

The liquid phosphate ester (FR-1) in the component (C) was, however, supplied from a downstream pressure feed nozzle to be melt-kneaded.

On this occasion, the screw rotation speed was set at 300 rpm, and the discharge rate at 15 kg/h.

The cylinder block had an opening (vent) through which residual volatile substances were removed by vacuum suction. On this occasion, the degree of vacuum (pressure) was 0.09 MPa.

The strand extruded from a die was cooled and continuously cut to produce pellets of the resin composition with a length of about 3 mm and a diameter of 3 mm by a cutter.

The pellets of resin composition thus produced were subjected to the above-mentioned various evaluations.

The evaluation results are shown together with the blending ratio of each component in the following Table 1 and Table 2.

[Table 1]

| | | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|---|
| (Composition) | | Component: part by mass | | | | | | | | | | | | |
| | (A) | (A-1) | PPE | 90.0 | 90.0 | 90.0 | 80.0 | 70.0 | 70.0 | 70.0 | 80.0 | 90.0 | 90.0 | 90.0 |
| | | (A-2) | PS | 5.0 | 5.0 | 5.0 | 15.0 | 25.0 | 25.0 | 25.0 | | 5.0 | 5.0 | 5.0 |
| | (B) | (B-2) | 64 ppm | 5.0 | 5.0 | 5.0 | 5.0 | 5.0 | 5.0 | | 20.0 | 5.0 | 5.0 | 5.0 |
| | | (B-1) | 1 ppm> | | | | | | | 5.0 | | | | |
| | (C) | (C-1) | FR-1 | 10.0 | 7.5 | 5.0 | 7.5 | 7.5 | 7.5 | 7.5 | 10.0 | | 12.5 | 7.5 |
| | | | FR-2 | | | | | | | | | 10.0 | | |
| | | (C-2) | FR-3 | 5.0 | 7.5 | 10.0 | 7.5 | 7.5 | 7.5 | 7.5 | 10.0 | 5.0 | 2.5 | |
| | | | FR-4 | | | | | | | | | | | 7.5 |
| | | (Others) | FR-5 | | | | | | | | | | | |
| | | | FR-6 | | | | | | | | | | | |
| | | | FR-7 | | | | | | | | | | | |
| | (D) | (D-1) | Tio2 | | | | | | 2.0 | | | | | |
| | (E) | (LDPE) | | 1.0 | 1.0 | 1.0 | 1.0 | 1.0 | 1.0 | 1.0 | 1.0 | 1.0 | 1.0 | 1.0 |
| | (F) | (F-1) | | 0.1 | 0.1 | 0.1 | 0.1 | 0.1 | 0.1 | 0.1 | 0.1 | 0.1 | 0.1 | 0.1 |
| | | (F-2) | | 0.1 | 0.1 | 0.1 | 0.1 | 0.1 | 0.1 | 0.1 | 0.1 | 0.1 | 0.1 | 01 |
| | TOTAL | | | 116.2 | 116.2 | 116.2 | 116.2 | 116.2 | 118.2 | 116.2 | 121.2 | 116.2 | 116.2 | 116.2 |
| (Material properties of resin composition) | | | | | | | | | | | | | | |
| | Resistance to heat aging UL-94, 1.5 mm | 0 hr | Rank | V-0 | V-0 | V-0 | V-0 | V-0 | V-0 | V-0 | V-0 | V-0 | V-0 | V-0 |
| | | 150°C 300 Hr | Rank | V-0 | V-0 | V-0 | V-0 | V-1 | V-0 | V-0 | V-0 | V-0 | V-1 | V-0 |
| | | 150°C 500 Hr | Rank | V-0 | V-0 | V-0 | V-1 | V-1 | V-0 | V-0 | V-0 | V-0 | V-1 | V-0 |

(continued)

| | | | | | | | | | | | | | | |
|---|---|---|---|---|---|---|---|---|---|---|---|---|---|---|
| (Material properties of resin composition) | | | | | | | | | | | | | | |
| | Charpy impact strength | | kJ/m2 | 20 | 18 | 16 | 18 | 19 | 18 | 18 | 37 | 20 | 20 | 15 |
| | Appearance | | | Good | Good | Fair | Good | Good | Good | Good | Good | Good | Good | Fair |
| | MD | | | Good | Good | Good | Good | Good | Good | Good | Good | Good | Good | Good |
| | | | | | | | | | | | | | | |
| (Analysis of resin composition) | | | | | | | | | | | | | | |
| | Residue amount (to 700°C) | 0 hr | wt% | 28.0 | 27.6 | 28.4 | - | 19.8 | - | - | 21.7 | - | - | - |
| | | 150°C 500 Hr | wt% | 31.0 | 30.5 | 31.6 | - | 21.8 | - | - | 24.0 | - | - | - |
| | Increasing ratio of residue amount | 150°C 500 Hr | % | 10.7 | 10.5 | 11.3 | - | 10.1 | - | - | 10.6 | - | - | - |

[Table 2]

| | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|
| (Composition) | Component: part by mass | | | | | | | | | |
| (A) | (A-1) | PPE | 90.0 | 90.0 | 90.0 | 90.0 | 90.0 | 60.0 | 40.0 | 80.0 |
| | (A-2) | PS | 5.0 | 5.0 | 5.0 | 5.0 | 5.0 | 35.0 | 55.0 | |
| (B) | (B-2) | 64 ppm | 5.0 | 5.0 | 5.0 | 5.0 | 5.0 | 5.0 | 5.0 | 20.0 |
| | (B-1) | 1 ppm> | | | | | | | | |
| (C) | (C-1) | FR-1 | 15.0 | | 7.5 | 7.5 | 7.5 | 7.5 | 7.5 | 20.0 |
| | | FR-2 | | | | | | | | |
| | (C-2) | FR-3 | | 15.0 | | | | 7.5 | 7.5 | |
| | | FR-4 | | | | | | | | |
| | (Others) | FR-5 | | | 7.5 | | | | | |
| | | FR-6 | | | | 7.5 | | | | |
| | | FR-7 | | | | | 7.5 | | | |
| (D) | (D-1) | Tio2 | | | | | | | | |
| (E) | (LDPE) | | 1.0 | 1.0 | 1.0 | 1.0 | 1.0 | 1.0 | 1.0 | 1.0 |
| (F) | (F-1) | | 0.1 | 0.1 | 0.1 | 0.1 | 0.1 | 0.1 | 0.1 | 0.1 |
| | (F-2) | | 0.1 | 0.1 | 0.1 | 0.1 | 0.1 | 0.1 | 0.1 | 0.1 |
| TOTAL | | | 116.2 | 116.2 | 116.2 | 116.2 | 116.2 | 116.2 | 116.2 | 121.2 |
| (Material properties of resin composition) | | | | | | | | | | |
| Resistance to heat aging UL-94, 1.5 mm | 0 hr | Rank | V-0 | V-0 | V-0 | V-0 | V-1 | V-0 | V-1 | V-0 |
| | 150°C 300 Hr | Rank | not V | V-1 | not V | not V | not V | V-1 | Unmeasurable | not V |
| | 150°C 500 Hr | Rank | not V | not V | not V | not V | not V | not V | Unmeasurable | not V |

(continued)

| | | | | | | | | | | | |
|---|---|---|---|---|---|---|---|---|---|---|---|
| (Material properties of resin composition) | | | | | | | | | | | |
| | Charpy impact strength | | kJ/m2 | 15 | 7 | 14 | 14 | 14 | 16 | 11 | 42 |
| | Appearance | | | Good | Poor | Good | Good | Good | Good | Good | Good |
| | MD | | | Good | Good | Poor | Poor | Good | Good | Good | Good |
| | | | | | | | | | | | |
| (Analysis of resin composition) | | | | | | | | | | | |
| | Residue amount (to 700°C) | 0 hr | wt% | 33.1 | 32.5 | 33.3 | 32.9 | 34.2 | - | - | 23.9 |
| | | 150°C 500 Hr | wt% | 38.5 | 36.6 | 38.4 | 37.7 | 39.3 | - | - | 27.7 |
| | Increasing ratio of residue amount | | % | 16.3 | 12.6 | 15.3 | 14.6 | 14.9 | - | - | 15.9 |

The present application is based on Japanese Patent Application No. 2013-272537 filed on December 27, 2013 in Japanese Patent Office.

Industrial Applicability

The flame retardant resin composition of the present invention has industrial applicability, capable of being used as junction boxes or connectors of a photovoataic generation module, components such as connectors, breakers, magnet switches in the electrical/electronic field, and component materials such as electrical components represented by relay blocks in the automobile field.

## Claims

1. A flame retardant resin composition comprising:

   70 to 99 parts by mass of a polyphenylene ether resin, or a mixed resin of a polyphenylene ether resin and a styrene-based resin (A);
   1 to 30 parts by mass of a hydrogenated block copolymer (B) ; and
   5 to 30 parts by mass of a phosphorus-containing flame retardant (C) based on the total 100 parts by mass of the (A) and the (B);
   wherein the component (A) comprises 70 to 100 % by mass of a polyphenylene ether resin (A-1) and 0 to 30 % by mass of a styrene-based resin (A-2); and
   the component (C) comprises a phosphate ester compound (C-1) and at least one selected from the group consisting of a phosphinate salt represented by the following general formula (I), a diphosphinate salt represented by the following general formula (II), and a condensate thereof (C-2):

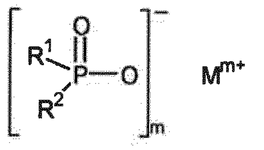

(I)

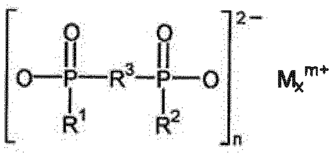

(II)

   wherein $R^1$ and $R^2$ are a linear or branched C1-C6 alkyl group or a C6-C10 aryl group may be the same or different;
   $R^3$ is any one selected from the group consisting of a linear or branched C1-C10 alkylene group, a C6-C10 arylene group, a C6-C10 alkylarylene group, and a C6-C10 arylalkylene group;
   M is one or more selected from the group consisting of a calcium ion, a magnesium ion, an aluminum ion, a zinc ion, a bismuth ion, a manganese ion, a sodium ion, a potassium ion, and a cationized nitrogen base;
   m is 1, 2 or 3; n is 1 to 3; x is 1 or 2; and 2n=mx,
   **characterized in that**
   the (C) comprises:

   50 to 70 % by mass of the phosphate ester compound (C-1) ; and
   30 to 50 % by mass of at least one selected from the group consisting of a phosphinate salt represented by the general formula (I), a diphosphinate salt represented by the general formula (II), and a condensate thereof (C-2).

2. The flame retardant resin composition according to claim 1, wherein the (A) comprises 80 to 100 % by mass of (A-1) and 0 to 20 % by mass of (A-2).

3. The flame retardant resin composition according to claim 1 or 2, wherein the (A) comprises 90 to 100 % by mass of (A-1) and 0 to 10 % by mass of (A-2).

4. The flame retardant resin composition according to any one of claims 1 to 3, wherein the phosphate ester compound (C-1) is a phosphate ester compound represented by the following general formula (III) or the general formula (IV):

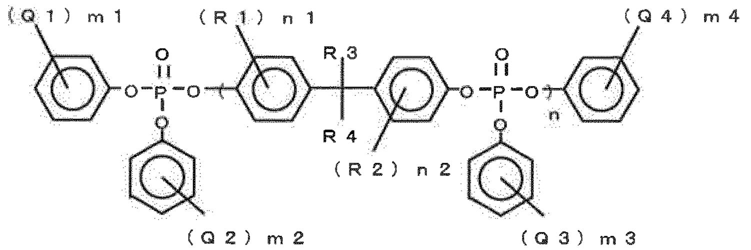

・・・(III)

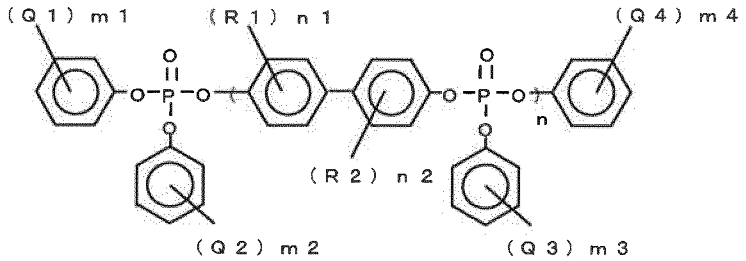

・・・(IV)

wherein Q1, Q2, Q3 and Q4 each independently represent an alkyl group having 1 to 6 carbon atoms, R1 and R2 represent a methyl group, and R3 and R4 each independently represent a hydrogen atom or a methyl group; n is an integer of 1 or more, n1 and n2 each independently represent an integer of 0 to 2, and m1, m2, m3 and m4 each independently represent an integer of 0 to 3.

5. The flame retardant resin composition according to any one of claims 1 to 4, further comprising titanium oxide (D), wherein the content of the titanium oxide (D) in the flame retardant resin composition is 0.1 to 5.0 % by mass.

6. The flame retardant resin composition according to any one of claims 1 to 5, wherein the component (C-2) has a volume-based average particle diameter (d50%), measured by a laser diffraction/scattering particle size distribution measuring device, of more than 1.0 μm and 10 μm or less.

7. The flame retardant resin composition according to any one of claims 1 to 6, having an inorganic filler content of 5.0 % by mass or less.

8. The flame retardant resin composition according to any one of claims 1 to 7, wherein the hydrogenated block copolymer (B) has a Li content of 100 ppm or less.

9. The flame retardant resin composition according to any one of claims 1 to 8, wherein increasing rate of residue amount that relate to the residue amount of an injection molded product of the flame retardant resin composition having a thickness of 1.5 mm obtained by thermogravimetric analysis (measurement conditions: temperature rising from room temperature to 700°C at a heating rate of 20°C/min under nitrogen atmosphere), and the residue amount of the injection molded product of the flame retardant resin composition having a thickness of 1.5 mm obtained by the thermogravimetric analysis after heat aging under conditions at 150°C for 500 hours is 12% or less.

10. The flame retardant resin composition according to any one of claims 1 to 9, wherein the injection molded product of the flame retardant resin composition having a thickness of 1.5 mm has a flame retardance specified in the UL-94 standard in the range of V-1 or higher, after heat aging under conditions at 150°C for 500 hours.

11. The flame retardant resin composition according to any one of claims 1 to 10, wherein the injection molded product having a thickness of 1.5 mm has a flame retardance specified in the UL-94 standard in the range of V-0, after heat aging under conditions at 150°C for 500 hours.

12. A connection structure for a photovoltaic power generation module comprising the flame retardant resin composition

according to any one of claims 1 to 11.

**13.** The connection structure for the photovoltaic power generation module according to claim 12, wherein the structure is a junction box for photovoltaic power generation modules.

**14.** The connection structure for the solar power generation module according to claim 12, wherein the structure is a connector for photovoltaic power generation modules.

**Patentansprüche**

**1.** Flammhemmende Harzzusammensetzung, umfassend:

70 bis 99 Massenteile eines Polyphenylenetherharzes oder eines gemischten Harzes aus einem Polyphenylenetherharz und einem Harz auf Styrolbasis(A);
1 bis 30 Massenteile eines hydrierten Blockcopolymers (B) ; und
5 bis 30 Massenteile eines Phosphor-enthaltenden Flammhemmers (C), bezogen auf die Gesamtheit von 100 Massenteilen der Komponente (A) und der Komponente (B);
wobei die Komponente (A) 70 bis 100 Massen-% eines Polyphenylenetherharzes (A-1) und 0 bis 30 Massen-% eines Harzes auf Styrolbasis (A-2) umfasst; und
wobei die Komponente (C) eine Phosphatesterverbindung (C-1) und mindestens eines, ausgewählt aus der Gruppe bestehend aus einem Phosphinatsalz der folgenden allgemeinen Formel (I), einem Diphosphinatsalz der folgenden allgemeinen Formel (II) und einem Kondensat davon (C-2), umfasst:

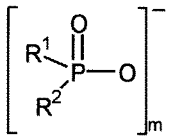 $M^{m+}$ (I)

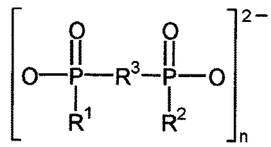 $M_x^{m+}$ (II)

worin $R^1$ und $R^2$ eine lineare oder verzweigte C1-C6-Alkylgruppe oder eine C6-C10-Arylgruppe sind und gleich oder verschieden sein können;
$R^3$ eines ist, ausgewählt aus der Gruppe bestehend aus einer linearen oder verzweigten C1-C10-Alkylengruppe, einer C6-C10-Arylengruppe, einer C6-C10-Alkylarylengruppe und einer C6-C10-Arylalkylengruppe;
M eines oder mehrere ist, ausgewählt aus der Gruppe bestehend aus einem Calciumion, einem Magnesiumion, einem Aluminiumion, einem Zinkion, einem Bismuthion, einem Manganion, einem Natriumion, einem Kaliumion und einer kationisierten Stickstoffbase; m 1, 2 oder 3 ist; n 1 bis 3 ist; x 1 oder 2 ist; und 2n=mx,
**dadurch gekennzeichnet, dass**
die Komponente (C) umfasst:

50 bis 70 Massen-% der Phosphatesterverbindung (C-1); und
30 bis 50 Massen-% mindestens eines, ausgewählt aus der Gruppe bestehend aus einem Phosphinatsalz der allgemeinen Formel(I), einem Diphosphinatsalz der allgemeinen Formel (II) und einem Kondensat davon (C-2).

**2.** Flammhemmende Harzzusammensetzung nach Anspruch 1, wobei die Komponente (A) 80 bis 100 Massen-% (A-1) und 0 bis 20 Massen-% (A-2) umfasst.

**3.** Flammhemmende Harzzusammensetzung nach Anspruch 1 oder 2, wobei die Komponente (A) 90 bis 100 Massen-% (A-1) und 0 bis 10 Massen-% (A-2) umfasst.

4. Flammhemmende Harzzusammensetzung nach einem der Ansprüche 1 bis 3, wobei die Phosphatesterverbindung (C-1) eine Phosphatesterverbindung der folgenden allgemeinen Formel (III) oder der allgemeinen Formel (IV) ist:

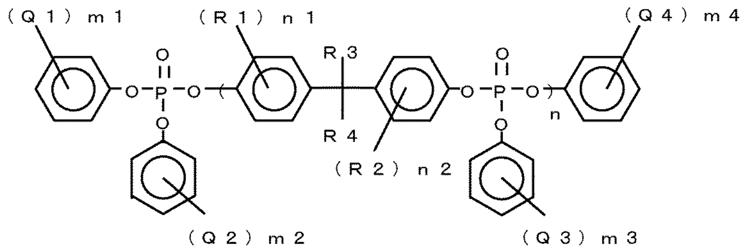

・・・(III)

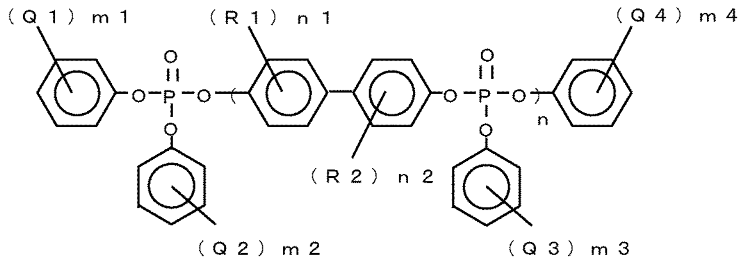

・・・(IV)

worin Q1, Q2, Q3 und Q4 jeweils unabhängig eine Alkylgruppe mit 1 bis 6 Kohlenstoffatomen darstellen, R1 und R2 eine Methylgruppe darstellen, und R3 und R4 jeweils unabhängig ein Wasserstoffatom oder eine Methylgruppe darstellen; n eine ganze Zahl von 1 oder mehr ist, n1 und n2 jeweils unabhängig eine ganze Zahl von 0 bis 2 darstellen, and m1, m2, m3 und m4 jeweils unabhängig eine ganze Zahl von 0 bis 3 darstellen.

5. Flammhemmende Harzzusammensetzung nach einem der Ansprüche 1 bis 4, weiterhin umfassend Titanoxid (D), wobei der Gehalt des Titanoxids (D) in der flammhemmenden Harzzusammensetzung 0,1 bis 5,0 Massen-% ist.

6. Flammhemmende Harzzusammensetzung nach einem der Ansprüche 1 bis 5, wobei die Komponente (C-2) einen volumen-basierten mittleren Teilchendurchmesser (d50%), gemessen mit einer Laserbeugungs/-streu-Teilchengrößenmessvorrichtung, von mehr als 1,0 μm und 10 μm oder weniger aufweist.

7. Flammhemmende Harzzusammensetzung nach einem der Ansprüche 1 bis 6, mit einem anorganischen Füllstoffgehalt von 5,0 Massen-% oder weniger.

8. Flammhemmende Harzzusammensetzung nach einem der Ansprüche 1 bis 7, wobei das hydrierte Blockcopolymer (B) einen Li-Gehalt von 100 ppm oder weniger aufweist.

9. Flammhemmende Harzzusammensetzung nach einem der Ansprüche 1 bis 8, wobei der Zunahmegrad der verbleibenden Menge in Bezug auf die verbleibende Menge eines Spritzgussprodukts aus der flammhemmenden Harzzusammensetzung mit einer Dicke von 1,5 mm, erhalten durch thermogravmetrische Analyse (Messbedingungen: Temperaturerhöhung von Raumtemperatur auf 700 °C bei einer Aufheizrate von 20°C/min unter Stickstoffatmosphäre), und der verbleibenden Menge des Spritzgussprodukts aus der flammhemmenden Harzzusammensetzung mit einer Dicke von 1,5 mm, erhalten durch thermogravimetrische Analyse nach Wärmealterung bei 150°C für 500 Stunden, 12% oder weniger ist.

10. Flammhemmende Harzzusammensetzung nach einem der Ansprüche 1 bis 9, wobei das Spritzgussprodukt aus der flammhemmenden Harzzusammensetzung mit einer Dicke von 1,5 mm nach Wärmealterung bei 150°C für 500 Stunden eine in demUL-94-Standard spezifizierte Flammhemmung im Bereich von V-1 oder höher aufweist.

11. Flammhemmende Harzzusammensetzung nach einem der Ansprüche 1 bis 10, wobei das Spritzgussprodukt aus der flammhemmenden Harzzusammensetzung mit einer Dicke von 1,5 mm nach Wärmealterung bei 150°C für 500 Stunden eine in dem UL-94-Standard spezifizierte Flammhemmung im Bereich von V-0 oder höher aufweist.

12. Verbindungsstruktur für ein photovoltaisches Stromerzeugungsmodul, umfassend die flammhemmende Harzzusammensetzung nach einem der Ansprüche 1 bis 11.

13. Verbindungsstruktur für ein photovoltaisches Stromerzeugungsmodul nach Anspruch 12, wobei die Struktur ein Verteilerkasten/Anschlusskasten für photovoltaische Stromerzeugungsmodule ist.

14. Verbindungsstruktur für ein photovoltaisches Stromerzeugungsmodul nach Anspruch 12, wobei die Struktur ein Verbindungsstück/ein Verbindungsstecker für photovoltaische Stromerzeugungsmodule ist.

## Revendications

1. Composition de résine retardatrice de flamme comprenant :

de 70 à 99 parties en masse d'une résine à base de poly(phénylène éther), ou d'un mélange de résines constitué d'une résine à base de poly(phénylène éther) et d'une résine à base de styrène (A) ;
de 1 à 30 parties en masse d'un copolymère séquencé hydrogéné (B) ; et
de 5 à 30 parties en masse d'un retardateur de flamme contenant du phosphore (C) sur la base du total de 100 parties en masse des composants (A) et (B) ;
dans laquelle le composant (A) comprend de 70 à 100 % en masse d'une résine à base de poly(phénylène éther) (A-1) et de 0 à 30 % en masse d'une résine à base de styrène (A-2) ; et
le composant (C) comprend un composé à base d'un ester de l'acide phosphorique (C-1) et au moins un choisi dans le groupe constitué d'un sel de phosphinate représenté par la formule générale (I) suivante, d'un sel de diphosphinate représenté par la formule générale (II) suivante, et d'un condensé de ceux-ci (C-2) :

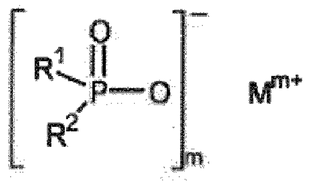

(I)

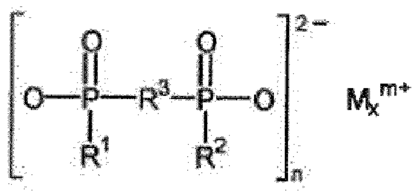

(II)

dans laquelle $R^1$ et $R^2$ sont un groupe alkyle en C1 à C6 linéaire ou ramifié ou un groupe aryle en C6 à C10 et peuvent être identiques ou différents ;
$R^3$ est l'un quelconque choisi dans le groupe constitué d'un groupe alkylène en C1 à C10 linéaire ou ramifié, d'un groupe arylène en C6 à C10, d'un groupe alkylarylène en C6 à C10 et d'un groupe arylalkylène en C6 à C10 ;
M est un ou plusieurs choisis dans le groupe constitué d'un ion de calcium, d'un ion de magnésium, d'un ion d'aluminium, d'un ion de zinc, d'un ion de bismuth, d'un ion de manganèse, d'un ion de sodium, d'un ion de potassium et d'une base d'azote cationisé ; m vaut 1, 2 ou 3 ; n vaut 1 à 3 ; x vaut 1 ou 2 ; et 2n = mx,
**caractérisée en ce que**
le composant (C) comprend :

de 50 à 70 % en masse du composé à base d'un ester de l'acide phosphorique (C-1) ; et
de 30 à 50 % en masse d'au moins un choisi dans le groupe constitué d'un sel de phosphinate représenté par la formule générale (I), d'un sel de diphosphinate représenté par la formule générale (II), et d'un condensé de ceux-ci (C-2).

2. Composition de résine retardatrice de flamme selon la revendication 1, dans laquelle le composant (A) comprend de 80 à 100 % en masse de (A-1) et de 0 à 20 % en masse de (A-2).

**3.** Composition de résine retardatrice de flamme selon la revendication 1 ou 2, dans laquelle le composant (A) comprend de 90 à 100 % en masse de (A-1) et de 0 à 10 % en masse de (A-2).

**4.** Composition de résine retardatrice de flamme selon l'une quelconque des revendications 1 à 3, dans laquelle le composé à base d'un ester de l'acide phosphorique (C-1) est un composé à base d'un ester de l'acide phosphorique représenté par la formule générale (III) suivante ou la formule générale (IV) :

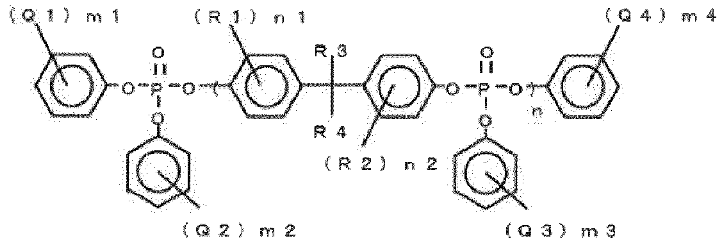

• • • (III)

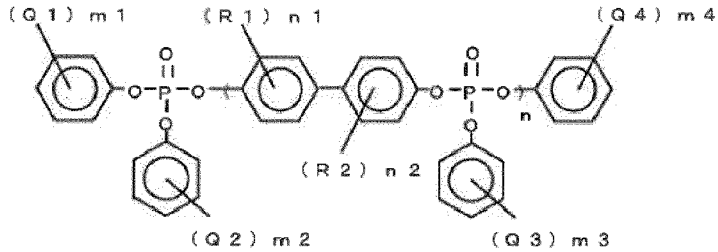

• • • (IV)

dans laquelle Q1, Q2, Q3 et Q4 représentent chacun indépendamment un groupe alkyle comportant de 1 à 6 atomes de carbone, R1 et R2 représentent un groupe méthyle, et R3 et R4 représentent chacun indépendamment un atome d'hydrogène ou un groupe méthyle ; n est un nombre entier de 1 ou plus, n1 et n2 représentent chacun indépendamment un nombre entier de 0 à 2, et m1, m2, m3 et m4 représentent chacun indépendamment un nombre entier de 0 à 3.

**5.** Composition de résine retardatrice de flamme selon l'une quelconque des revendications 1 à 4, comprenant en outre de l'oxyde de titane (D), dans laquelle la teneur de l'oxyde de titane (D) dans la composition de résine retardatrice de flamme est de 0,1 à 5,0 % en masse.

**6.** Composition de résine retardatrice de flamme selon l'une quelconque des revendications 1 à 5, dans laquelle le composant (C-2) a un diamètre moyen de particule sur une base volumique (d50%), mesuré par un dispositif de mesure de la répartition de la taille de particule par diffraction/diffusion, de plus de 1,0 μm et de 10 μm ou moins.

**7.** Composition de résine retardatrice de flamme selon l'une quelconque des revendications 1 à 6, ayant une teneur en charge inorganique de 5,0 % en masse ou moins.

**8.** Composition de résine retardatrice de flamme selon l'une quelconque des revendications 1 à 7, dans laquelle le copolymère séquencé hydrogéné (B) a une teneur en Li de 100 ppm ou moins.

**9.** Composition de résine retardatrice de flamme selon l'une quelconque des revendications 1 à 8, dans laquelle le taux d'augmentation de la quantité de résidu liée à la quantité de résidu d'un produit moulé par injection de la composition de résine retardatrice de flamme ayant une épaisseur de 1,5 mm obtenue par analyse thermogravimétrique (conditions de mesure : élévation de la température de la température ambiante à 700 °C à une vitesse de chauffage de 20 °C/min dans une atmosphère d'azote), et à la quantité de résidu du produit moulé par injection de la composition de résine retardatrice de flamme ayant une épaisseur de 1,5 mm obtenue par l'analyse thermogravimétrique après vieillissement à la chaleur dans des conditions à 150 °C pendant 500 heures, est de 12 % ou moins.

**10.** Composition de résine retardatrice de flamme selon l'une quelconque des revendications 1 à 9, dans laquelle le

produit moulé par injection de la composition de résine retardatrice de flamme ayant une épaisseur de 1,5 mm a une propriété retardatrice de flamme spécifiée dans la norme UL-94 dans la plage de V-1 ou supérieure, après vieillissement à la chaleur dans des conditions à 150 °C pendant 500 heures.

**11.** Composition de résine retardatrice de flamme selon l'une quelconque des revendications 1 à 10, dans laquelle le produit moulé par injection ayant une épaisseur de 1,5 mm a une propriété retardatrice de flamme spécifiée dans la norme UL-94 dans la plage de V-0, après vieillissement à la chaleur dans des conditions à 150 °C pendant 500 heures.

**12.** Structure de connexion pour un module de production d'électricité photovoltaïque comprenant la composition de résine retardatrice de flamme selon l'une quelconque des revendications 1 à 11.

**13.** Structure de connexion pour le module de production d'électricité photovoltaïque selon la revendication 12, dans laquelle la structure est une boîte de jonction pour modules de production d'électricité photovoltaïque.

**14.** Structure de connexion pour le module de production d'électricité solaire selon la revendication 12, dans laquelle la structure est un connecteur pour modules de production d'électricité photovoltaïque.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 55118957 A
- JP 5186681 A
- JP 7053876 A
- JP 2000508365 A
- JP 2010123933 A
- JP 20132342883 B
- JP 52017880 A
- US 3306874 A
- US 3306875 A
- US 3257357 A
- US 3257358 A
- JP 50051197 A
- JP 63152628 A
- EP 699708 A
- JP 8073720 A
- JP 11181429 A
- JP 59133203 A
- JP 2013272537 A